(19) Europäisches Patentamt
European Patent Office
Office européen des brevets

(11) **EP 1 274 211 B1**

(12) **EUROPEAN PATENT SPECIFICATION**

(45) Date of publication and mention
of the grant of the patent:
**11.04.2007  Bulletin 2007/15**

(51) Int Cl.:
***H04L 27/26*** (2006.01)

(21) Application number: **02254004.1**

(22) Date of filing: **10.06.2002**

(54) **Orthogonal frequency division multiplex signal demodulator circuit having a simple circuit configuration**

OFDM Demodulatorschaltung mit einfacher Schaltungsanordnung

Circuit démodulateur OFDM ayant une configuration de circuit simplifié

(84) Designated Contracting States:
**DE FR GB SE**

(30) Priority: **21.06.2001  JP  2001188389**

(43) Date of publication of application:
**08.01.2003  Bulletin 2003/02**

(73) Proprietor: **ALPS ELECTRIC CO., LTD.**
**Ota-ku**
**Tokyo (JP)**

(72) Inventor: **Ohtaki, Yukio,**
**c/o Alps Electric Co., Ltd**
**Tokyo (JP)**

(74) Representative: **Kensett, John Hinton**
**Saunders & Dolleymore,**
**9 Rickmansworth Road**
**Watford,**
**Hertfordshire WD18 0JU (GB)**

(56) References cited:
**EP-A- 1 071 221**

- **WARD C R ET AL: "The application of acoustic charge transport technologies to wideband communication systems" PROCEEDINGS OF THE NATIONAL TELESYSTEMS CONFERENCE (NTC). WASHINGTON, MAY 19 - 20, 1992, NEW YORK, IEEE, US, 19 May 1992 (1992-05-19), pages 15-1-1512, XP010059553 ISBN: 0-7803-0554-X**

**Description**

BACKGROUND OF THE INVENTION

1. Field of the Invention

The present invention relates to an orthogonal frequency division multiplex (OFDM) signal demodulator circuit and, more particularly, to an OFDM signal demodulator circuit that uses a digital all pass filter and a digital signal delay circuit for a digital quadrature signal detector producing in-phase signals and quadrature signals and that includes a frequency shifter for shifting the frequencies of an in-phase signal and a quadrature signal to a baseband so as to secure compatibility with a known circuit without using many components.

2. Description of the Related Art

In recent years, the field of broadcasting is focusing increasing attention on ground wave digital broadcasting rather than the conventional ground wave analog broadcasting because the ground wave digital broadcasting exhibits better broadcast quality and permits more broadcast channels to be provided. Full-scale broadcast operations based on such ground wave digital broadcast have already been started in European countries and the United States. In Japan also, the ground wave digital broadcast is expected to come into practical use soon.

The ground wave digital broadcast adopted in Europe and Japan uses the OFDM modulating system for modulating broadcast signals. A broadcast receiver capable of receiving the ground wave digital broadcast (hereinafter referred to as "the ground wave digital broadcast receiver") is equipped with a tuner for receiving broadcast signals, amplifying received signals, and converting the received signals into intermediate-frequency signals, and a quadrature frequency division multiplex signal demodulator circuit that carries out quadrature frequency division multiplex demodulation on the intermediate-frequency signals supplied from the tuner. The quadrature frequency division multiplex signal demodulator circuit uses a digital quadrature signal detector for detecting an in-phase (I) signal (hereinafter referred to as "signal I") and a quadrature (Q) signal (hereinafter referred to as "signal Q") from received signals, and a quadrature frequency division multiplex detector for detecting quadrature frequency division multiplex signals.

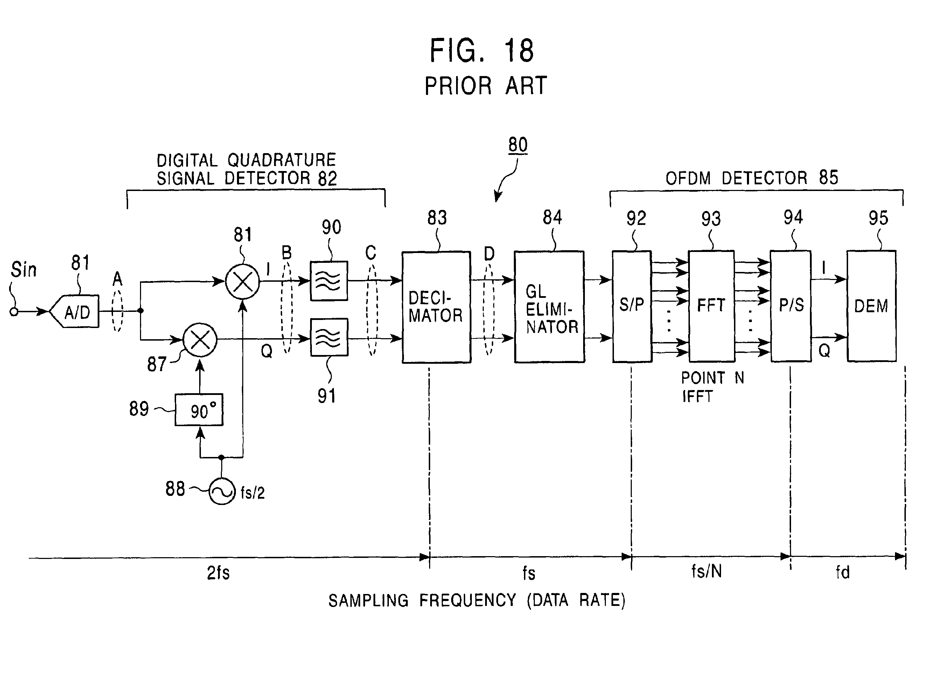

Fig. 18 is a block diagram showing an example of the configuration of a quadrature frequency division multiplex signal demodulator circuit used with a known ground wave digital broadcast receiver.

Referring to Fig. 18, an OFDM signal demodulator circuit 80 is constructed of an analog/digital converter (A/D) 81, a digital quadrature signal detector 82, a decimator 83 that decimates signals by a degree 2, an undesired signal eliminator (GI eliminator) 84, an orthogonal frequency division multiplex signal detector (OFDM signal detector) 85, and a signal input terminal Sin. In this case, the digital quadrature signal detector 82 has a first mixer 86, a second mixer 87, a local oscillator 88, and a 90-degree phase shifter 89, a first low-pass filter 90, and a second low-pass filter 91. The quadrature frequency division multiplex signal detector 85 has a serial-parallel converter (S/P) 92, a fast Fourier transformer (FFT) 93, a parallel-serial converter (P/S) 94, and a digital demodulator (DEM) 95.

The analog/digital converter 81 has its input end connected to a signal input terminal Sin and its output end connected to the first input ends of the first mixer 86 and the second mixer 87, respectively. The first mixer 86 has its second input end connected to an output end of the local oscillator 88, and its output end connected to an input end of the first low-pass filter 90. The second mixer 87 has its second input end connected to an output end of the local oscillator 88 through the intermediary of the 90-degree phase shifter 89, and its output end connected to an input end of the second low-pass filter 91. The decimator 83 has its I signal input end connected to an output end of the first low-pass filter 90, its signal Q input end connected to an output end of the second low-pass filter 91, its I signal output end connected to the signal I input end of the undesired signal eliminator 84, and its signal Q input end connected to a signal Q output end of the undesired signal eliminator 84. The serial-parallel converter 92 has its signal I input end connected to a signal I output end of the undesired signal eliminator 84, its signal Q input end connected to a signal Q output end of the undesired signal eliminator 84, and its multiple output ends individually connected to corresponding multiple input ends of the fast Fourier transformer 93. The parallel-serial converter 94 has its multiple input ends individually connected to the corresponding multiple output ends of the fast Fourier transformer 93, its I signal output end connected to an I signal input end of the digital demodulator 95, and its Q signal output end connected to a signal Q input end of the digital demodulator 95.

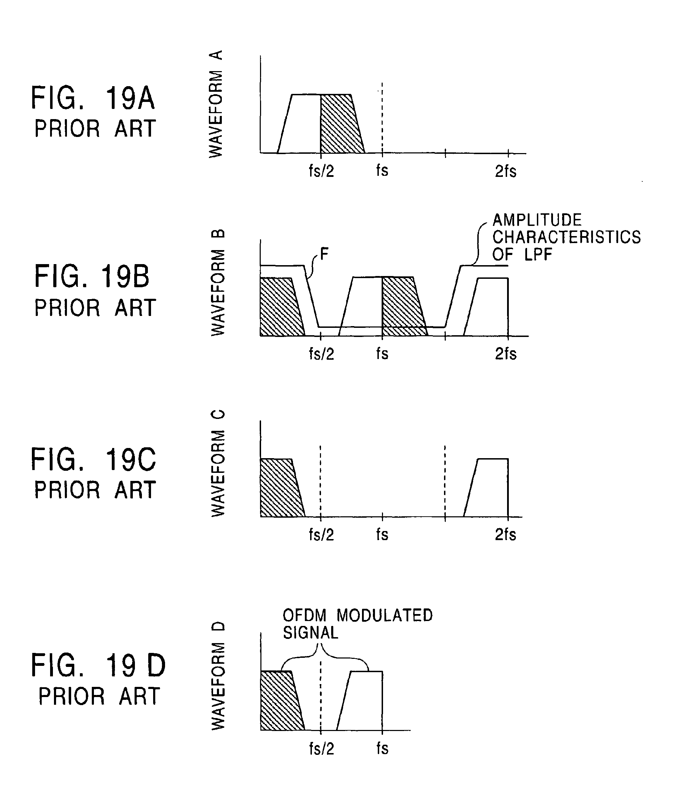

Figs. 19A through 19D show signal spectra (signal waveforms) obtained at several portions of the OFDM signal demodulator circuit 80 shown in Fig. 18. Fig. 19A shows digital signal waveform A output from the analog/digital converter 81, Fig. 19B shows waveforms B of signal I and signal Q output from the first and second mixers 86 and 87, Fig. 19C shows waveforms C of signal I and signal Q output from the first and second low-pass filters 90 and 91, respectively, and Fig. 19D shows signal I and signal Q of waveforms D output from the decimator 83.

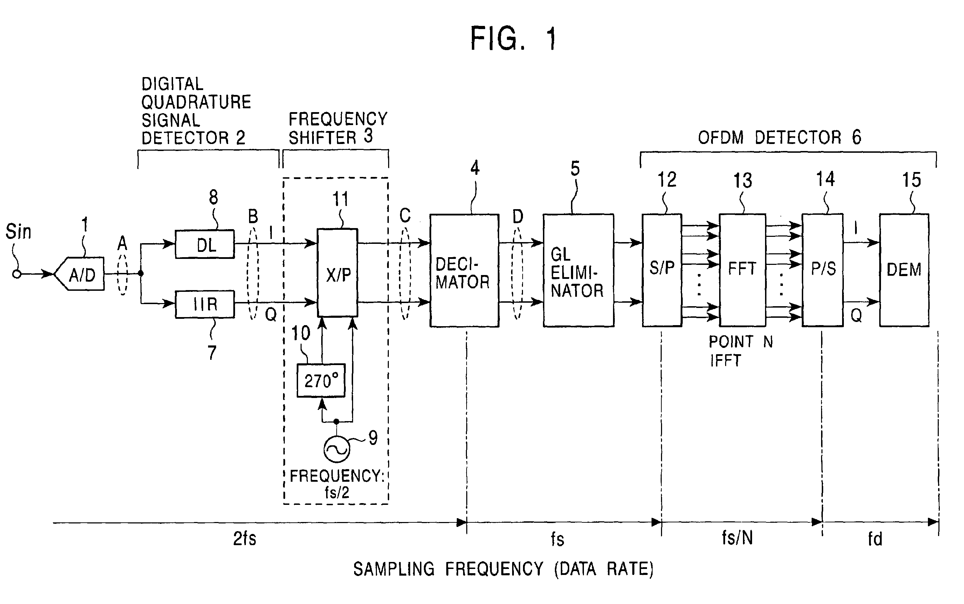

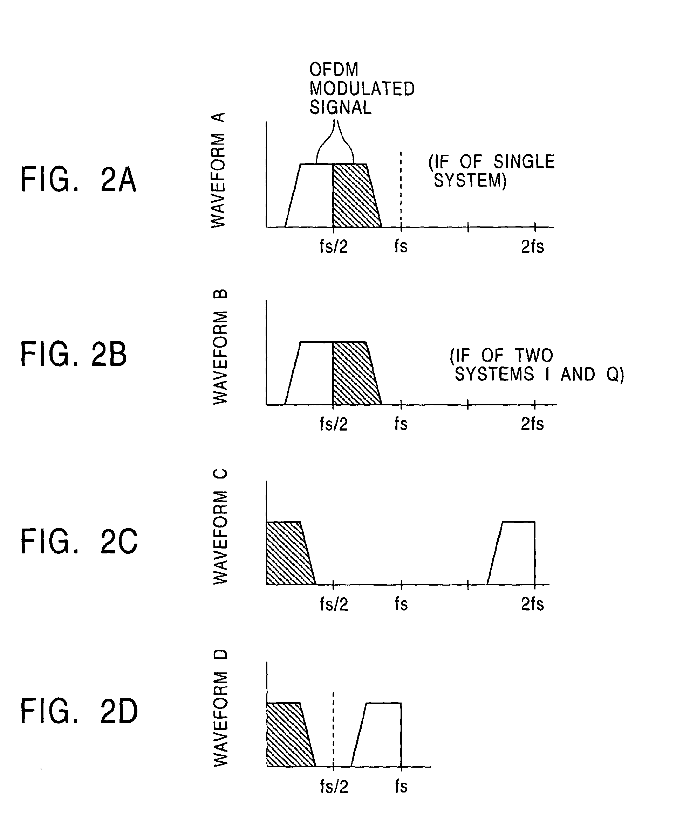

The operation of the OFDM signal demodulator circuit 80 having the configuration described above will now be described in conjunction with Fig. 1 and Fig. 2.

When ground wave digital broadcast is received by the ground wave digital broadcast receiver, a tuner (not shown) amplifies a received signal and converts the frequency thereof to produce an intermediate frequency signal. The intermediate frequency signal is supplied to the output analog/digital converter 81 through the signal input terminal Sin. The analog/digital converter 81 carries out analog-to-digital conversion on the supplied intermediate frequency signal at a sampling frequency 2fs thereby to produce a digital signal. The digital signal has signal waveform A shown in Fig. 19A.

In the digital quadrature signal detector 82, the first mixer 86 mixes the frequencies of the digital signal with the oscillation signal of the local oscillator 88 to create a first mixed signal. The second mixer 87 mixes the frequencies of the digital signal with the oscillation signal of the local oscillator 88 that has been phase-shifted by 90 degrees by the 90-degree phase shifter 89 thereby to create a second mixed signal. The first and second mixed signals have signal waveform B shown in Fig. 19B. The first band-pass filter 90 and the second band-pass filter 91, which have the pass band characteristic indicated by curve F shown in Fig. 19B, decimate signal I and signal Q from the first mixed signal and the second mixed signal. The decimated signal I and signal Q have signal waveform C shown in Fig. 19C.

The decimator 83 carries out decimation of signals of the degree 2 at a sampling frequency fs from the supplied signal I and signal Q to decimate signal I and signal Q. The decimated signal I and signal Q have signal waveform D shown in Fig. 19D. The undesired signal eliminator 84 removes undesired signal components from the decimated in-phase signal and quadrature signal, and outputs only the pure decimated signal I and signal Q.

In the OFDM signal detector 85, the serial-parallel converter 92 carries out serial-parallel conversion on the decimated signal I and signal Q that have been supplied, and outputs the converted signals. The fast Fourier transformer 93 carries out fast Fourier transformation based on point N on signal I and signal Q that have been supplied in parallel, and outputs the processed signals in parallel. The parallel-serial converter 94 converts the parallel processed signals into serial signal I and signal Q, and outputs the converted signals. The digital demodulator 95 carries out demodulation for the digital modulation, such as quadrature phase shift keying (QPSK), on the supplied signal I and signal Q, and outputs demodulated signals.

The quadrature frequency division multiplex signal demodulator circuit 80 used with the above known ground wave digital broadcast receiver requires the first and second band-pass filters 90 and 91 used with the digital quadrature signal detector 82 that have a signal attenuation characteristic of approximately 60 dB. For this reason, it is necessary to use a large-scale finite impulse response (FIR) digital filter having many filter orders (the number of signal processing stages). To construct such a large-scale FIR digital filter, many circuit components are required, inevitably leading to a larger volume occupying by the digital filter and increased power consumed by the digital filter.

Furthermore, in the quadrature frequency division multiplex signal demodulator circuit 80 used with the above known ground wave digital broadcast receiver, the digital quadrature signal detector 82 includes the four individual circuits, namely, the first mixer 86, the second mixer 87, the local oscillator 88, and the 90-degree phase shifter 89. Hence, many circuit components are required to constitute the individual circuits 86 through 89, adding also to the volume occupying by the digital quadrature signal detector 82 and the power consumed by the digital quadrature signal detector 82.

There has also been proposed by the present inventor a frequency division multiplex signal demodulator circuit that has a digital quadrature signal detector constituted by a digital signal delay circuit and an infinite impulse response digital filter. This arrangement restrains an increase of the number of circuit components and an increase of the volume occupying by the digital quadrature signal detector in constructing the digital quadrature signal detector in the frequency division multiplex signal demodulator circuit used with a ground wave digital broadcast receiver.

In the frequency division multiplex signal demodulator circuit, the digital quadrature signal detector adopts the infinite impulse response digital filter to permit the restraint of an increase in the number of circuit components or volume occupying thereby. However, intermediate frequency signals are supplied to a fast Fourier transformer following the digital quadrature signal detector, thus making it impossible to secure compatibility with a known frequency division multiplex signal demodulator circuit.

The article by Word: "The application of acoustic charge transport technologies to wideband communication systems", Proceedings of the National Telesystems Conference, 19.5.1992, pages 15-1 to 15-12, ISBN 0-7803-0554-x, XP 010059553 considers the application of acoustic charge transport technology to wideband communication systems, discussing the use of time domain techniques.

EP 1 071 221 discloses a method for reducing the power of a radio receiver and discusses an RF tuner that down converts a broadcast signal so that it can be sampled by an analogue-to-digital converter; extracts individual frequency components using fast Fourier transform; and decodes the frequency components which includes differentia quadrature phase shift and keying.

SUMMARY OF THE INVENTION

In view of the above technological background, the present invention has been made to attain the objective of providing an orthogonal frequency division multiplex signal demodulator circuit that allows a simpler circuit configuration, a reduced occupying volume, and reduced power consumption to be achieved by using a single system of digital filter and a single system of digital signal delay circuit.

To this end, according to one aspect of the present invention, there is provided an orthogonal frequency division multiplex signal demodulator circuit having an analog/digital converter that carries out analog/digital conversion at a sampling frequency on a received signal whose central frequency is non-zero and outputs a digital signal, a digital quadrature signal detector constructed of a digital signal delay circuit that delays the digital signal to create signal I and a digital all pass filter that shifts the phase of the digital signal by 90 degrees to produce signal Q, a frequency shifter that shifts the frequencies of signal I and signal Q to turn them into baseband signals having their central frequencies set at zero, and an orthogonal frequency division multiplex detector constructed of a fast Fourier transformer for carrying out fast Fourier transformation on the baseband signals and a digital demodulator for demodulating the digital signal that has been subjected to the fast Fourier transformation, wherein the digital all pass filter is an infinite impulse response digital filter having a predetermined group delay characteristic, and the digital signal delay circuit has a signal delay amount equal to the group delay amount of the digital all pass filter.

With this arrangement, the digital quadrature signal detecting circuit has a single system of digital signal delay circuit for creating signals I and a single system of digital all pass filter for creating signals Q, and the infinite impulse response digital filter is used for the digital all pass filter. Hence, an orthogonal frequency division multiplex signal demodulator circuit can be obtained that considerably reduces the required number of circuits, as compared with a known digital quadrature signal detecting circuit of this type. Furthermore, the infinite impulse response digital filter that has less filter degrees (the number of stages in a signal processor) than a finite impulse response digital filter, making it possible to achieve a simpler circuit configuration with a smaller number of components, a smaller volume occupying, and reduced power consumption. In addition, to implement fast Fourier transformation, an in-phase signal and a quadrature signal are frequency-shifted into baseband signals having their central frequencies at zero by using a frequency shifter, making it possible to accomplish an orthogonal frequency division multiplex signal demodulator circuit that secures compatibility with a known orthogonal frequency division multiplex signal demodulator circuit.

Alternatively, a first connecting device may be used in which a signal decimator that decimates signals I and signals Q by a degree 2 is connected to the output end of the frequency shifter, or a second connecting device may be used in which a signal decimator that decimates baseband signals having their central frequencies set at zero by degree 2 is connected to the input end thereof.

Use of the first connecting device or the second connecting device makes it possible to arbitrarily set the relationship of connection between the frequency shifter and the signal decimator. Especially when the second connecting means is used, the sampling frequencies of signals I and signals Q supplied to a complex multiplier will be reduced in half, permitting the power consumption of the complex multiplier to be cut in half.

Preferably, the frequency shifter is constructed of an oscillator that generates a multiplication signal of a frequency fs/2, which is half the sampling frequency fs, a phase shifter that produces a quadrature multiplication signal from the multiplication signal, and a complex multiplier that produces complex sum of products signals of the multiplication signal and the quadrature multiplication signal for an in-phase signal and a quadrature signal so as to output baseband signals, one cycle of which consisting of 4 or 2 sampling points.

With this arrangement, it is possible to markedly simplify the construction of the complex multiplier, which is formed of two switches and a phase inverter, resulting in reduced power consumption.

The infinite impulse response digital filter may have a first construction wherein each of the signal processors of an arbitrary integer n of stages of three or more connected in concatenation has a first delayer, a second delayer, an adder, a multiplier, and a multiplication coefficient generator, and the constants of all associated components are set such that the phase gradient number generated in a signal band having its center set at a quarter of a sampling frequency is n-1.

With this arrangement, the phase difference between the quadrature signals output from the single infinite impulse response digital filter and the in-phase signal output from the digital signal delay circuit can be controlled to a small variation range in a desired frequency band. This permits improved conversion characteristic to be achieved in addition to the advantages described above.

Preferably, in the n stages of signal processors connected in concatenation, the signal processors of odd-numbered stages from the output end are constructed of only first delayers and second delayers.

With this arrangement, the signal processors of odd-numbered stages from the output end in the n stages of signal processors connected in concatenation are constructed of only the first delayers and the second delayers, thus omitting adders, multipliers, and multiplication coefficient generators. Thus, the number of components can be reduced due to the absence of the adders, the multipliers, and the multiplication coefficient generators, so that the occupying volume can be reduced and the power consumption can be reduced accordingly.

Preferably, in the n stages of signal processors connected in concatenation of the first construction, when the outputs of the infinite impulse response digital filter are decimated by degree 2 and output, the operating frequency of the infinite impulse response digital filter is set to the half of a sampling frequency, and the n stages of signal processors connected in concatenation are constructed of only the signal processors of even-numbered stages from the output end.

With this arrangement, only the signal processors of the even-numbered stages from the output end are used, omitting all the signal processors of the odd-numbered stages from the output end in the n stages of signal processors connected in concatenation. Hence, the number of components can be significantly reduced due to the omitted odd-numbered stages of signal processors, allowing a further simpler circuit configuration to be accomplished with a resultant marked reduction in the occupying volume and in power consumption.

An embodiment of the present invention will now be described, by way of example only, with reference to the accompanying diagrammatic drawings, in which:

Fig. 1 is a block diagram showing the configuration of an essential section of an orthogonal frequency division multiplex signal demodulator circuit according to a first embodiment of the present invention;

Fig. 2 shows signal spectra (signal waveforms) obtained at components of the orthogonal frequency division multiplex signal demodulator circuit shown in Fig. 1;

Fig. 3 is a circuit diagram showing a first construction example of an infinite impulse response digital filter used with a digital quadrature signal detector shown in Fig. 1;

Fig. 4 is a schematic representation illustrating the phase changes of the infinite impulse response digital filter;

Fig. 5 is a schematic representation illustrating the group delay characteristic of the infinite impulse response digital filter and the delay characteristic of a digital signal delay circuit;

Fig. 6 is a characteristic diagram illustrating the phase changes observed with different phase gradient numbers generated in a frequency band in the infinite impulse response digital filter;

Fig. 7 is a characteristic diagram illustrating the phase changes observed in a frequency band in the infinite impulse response digital filter shown in Fig. 6;

Fig. 8 is a characteristic diagram illustrating the changes in group delay obtained when a phase gradient number is used as a parameter in the infinite impulse response digital filter;

Fig. 9 is a table showing exemplary coefficient values set at a multiplication coefficient generator that are obtained when a phase gradient number to be generated and the number of disposed signal processing stages are decided in an infinite impulse response digital filter;

Fig. 10 is a table showing a further generalized relationship among the phase gradients, the number of coefficients, and the coefficient values of the coefficients shown in Fig. 9;

Fig. 11 is a circuit diagram showing a second construction example of the infinite impulse response digital filter used with the digital quadrature signal detector shown in Fig. 1;

Fig. 12 is a circuit diagram showing a third construction example of the infinite impulse response digital filter used with the digital quadrature signal detector shown in Fig. 1;

Fig. 13 is a schematic diagram showing the specific details of a complex multiplier of a frequency shifter used with the orthogonal frequency division multiplex signal demodulator circuit shown in Fig. 1;

Fig. 14 is a block diagram showing the configuration of an essential section of the orthogonal frequency division multiplex signal demodulator circuit according to a second embodiment of the present invention;

Fig. 15 shows signal spectra (signal waveforms) obtained at components of the second embodiment shown in Fig. 14;

Fig. 16 is a schematic representation showing the specific details of the complex multiplier of the frequency shifter used with the orthogonal frequency division multiplex signal demodulator circuit shown in Fig. 14;

Fig. 17 is a block diagram showing the configuration of an essential section of an orthogonal frequency division multiplex signal demodulator circuit according to a third embodiment of the present invention;

Fig. 18 is a block diagram showing an example of the configuration of an orthogonal frequency division multiplex signal demodulator circuit used with a known ground wave digital broadcast receiver; and

Fig. 19 shows signal spectra (signal waveforms) obtained at components of the orthogonal frequency division multiplex signal demodulator circuit shown in Fig. 18.

DESCRIPTION OF THE PREFERRED EMBODIMENTS

The following will describe the embodiments in accordance with the present invention with reference to the accompanying drawings.

Fig. 1 is a block diagram showing the configuration of an essential section of an orthogonal frequency division multiplex signal demodulator circuit according to a first embodiment of the present invention.

Referring to Fig. 1, the orthogonal frequency division multiplex signal demodulator circuit according to the first embodiment is constructed of an analog/digital (A/D) converter 1, a digital quadrature signal detector 2, a frequency shifter 3, a decimator 4 for decimating signals by the degree 2, an undesired signal eliminator (GI eliminator) 5, an orthogonal frequency division multiplex detector (OFDM detector) 6, and a signal input terminal Sin.

In this case, the digital quadrature signal detector 2 is formed of an infinite impulse response (IIR) digital filter 7 and a digital signal delay circuit (DL) 8. The frequency shifter 3 is formed of a local oscillator 9, a 270-degree phase shifter 10, and a complex multiplier (cross product computing unit) 11. The OFDM detector 6 is formed of a serial-parallel converter (S/P) 12, a fast Fourier transformer (FFT) 13, a parallel-serial converter (P/S) 14, and a digital demodulator (DEM) 15. In this case, the 270-degree phase shifter 10 may be replaced by a 90-degree phase shifter.

The IIR digital filter 7 is an all pass filter that shifts the phase of an input digital signal by 90 degrees to produce a signal Q. The DL 8 provides the input digital signal with a signal delay equivalent to a signal group delay amount of the IIR digital filter 7 to produce signal I. The local oscillator 9 generates a multiplication signal (local oscillation signal) of a frequency fs/2, which is half a sampling frequency fs. The 270-degree phase shifter 10 shifts the phase of the multiplication signal by 270 degrees to produce a quadrature multiplication signal. The complex multiplier 11 creates complex sum of products signals of the multiplication signal and the quadrature multiplication signal for the signal I and signal Q supplied from the digital quadrature signal detector 2. The serial-parallel converter 12 converts serial-input signal I and signal Q into parallel-output signal I and signal Q. The FFT 13 carries out fast Fourier transformation based on point N on the signal I and signal Q that have been supplied in parallel. The parallel-serial converter 14 converts parallel-input signal I and signal Q into serial-output signal I and signal Q. The DEM 15 carries out demodulation for the digital modulation, such as quadrature phase shift keying (QPSK), on the supplied signal I and signal Q.

The analog/digital converter 1 has its input end connected to a signal input terminal Sin and its output end connected to the input ends of the IIR digital filter 7 and the DL 8. The output end of the IIR digital filter 7 is connected to a signal Q input end of the complex multiplier 11, and the output end of the DL 8 is connected to a signal I input end of the complex multiplier 11. The multiplication signal input end of the complex multiplier 11 is connected to an output end of the local oscillator 9, the quadrature multiplication signal input end thereof is connected to the output end of the local oscillator 9 through the intermediary of the 270-degree phase shifter 10, the signal I output end thereof is connected to the signal I input end of the decimator 4, and the signal Q output end thereof is connected to the signal Q input end of the decimator 4.

The decimator 4 has its signal I output end connected to the signal I input end of the undesired signal eliminator 5 and its signal Q output end connected to the signal Q input end of the undesired signal eliminator 5. The undesired signal eliminator 5 has its signal I output end connected to the signal I input end of the serial-parallel converter 12, and its signal Q output end connected to the signal Q input end of the serial-parallel converter 12. The output ends of the serial-parallel converter 12 are connected to the associated input ends of the fast Fourier transformer 13. The output ends of the fast Fourier transformer 13 are connected to the associated input ends of the parallel-serial converter 14. The parallel-serial converter 14 has its signal I output end connected to the signal I input end of the DEM 15 and its signal Q output end connected to the signal Q input end of the DEM 15.

Figs. 2A through 2D show the signal spectra (signal waveforms) obtained at components of the OFDM signal demodulator circuit shown in Fig. 1. Fig. 2A shows digital signal waveform A output from the analog/digital converter 1, Fig. 2B shows waveform B of signal I and signal Q output from the digital quadrature signal detector 2, Fig. 2C shows waveform C of signal I and signal Q output from the complex multiplier 11, and Fig. 2D shows waveform D of signal I and signal Q output from the decimator 4.

The operation of the OFDM signal demodulator circuit according to the embodiment having the configuration described above will now be explained in conjunction with Fig. 1 and Fig. 2.

When a tuner (not shown) receives a ground wave digital broadcast signal, the tuner amplifies the received signal, then mixes the frequencies of the amplified received signal and a local oscillation signal to produce a frequency-mixed signal. The tuner extracts an intermediate frequency (IF) signal from the produced frequency-mixed signal, and supplies the obtained IF signal to the analog/digital converter 1 through the signal input terminal Sin. The analog/digital converter 1 carries out analog-digital conversion on the supplied IF signal at a sampling frequency 2fs so as to generate a digital signal. This digital signal having signal waveform A shown in Fig. 2A is supplied to the subsequent digital quadrature signal detector 2.

In the digital quadrature signal detector 2, the IIR digital filter 7 shifts the phase of the supplied digital signal by 90 degrees to generate signal Q. The DL 8 processes the supplied digital signal to generate signal I delayed by the signal delay amount equal to the signal group delay amount imparted to the digital signal whose phase is shifted by 90 degrees at the IIR digital filter 7. These signal I and signal Q having the signal waveform B shown in Fig. 2B are respectively supplied to the subsequent frequency shifter 3.

In the frequency shifter 3, the complex multiplier 11 generates complex sum of products signals of the supplied multiplication signal and the quadrature multiplication signal for the supplied signal I and signal Q, and outputs them as frequency-shifted signal I and signal Q. The signal I and signal Q thus obtained having signal waveform C shown in Fig. 2C are respectively supplied to the subsequent decimator 4.

The decimator 4 thins signals of a degree 2 out at a sampling frequency fs from the supplied signal I and signal Q to decimate signal I and signal Q. The signal I and signal Q after the decimation that exhibit signal waveform D shown in Fig. 2D are respectively supplied to the following undesired signal eliminator 5. The undesired signal eliminator 5 removes undesired signal components from the signal I and signal Q that have undergone the decimation, and supplies only the pure decimated signal I and signal Q to the subsequent OFDM detector 6.

In the OFDM detector 6, the serial-parallel converter 12 carries out serial-parallel conversion on the decimated signal I and signal Q that are serially supplied, and outputs the signals as parallel signals. The FFT 13 carries out fast Fourier transformation based on point N on the signal I and signal Q that have been supplied in parallel, and outputs the processed signals in parallel. The parallel-serial converter 14 carries out parallel to serial conversion on the parallel signals, and outputs the signals as serial signal I and signal Q. The DEM 15 carries out demodulation for the digital modulation, such as quadrature phase shift keying (QPSK), on the supplied signal I and signal Q, and outputs demodulated signals.

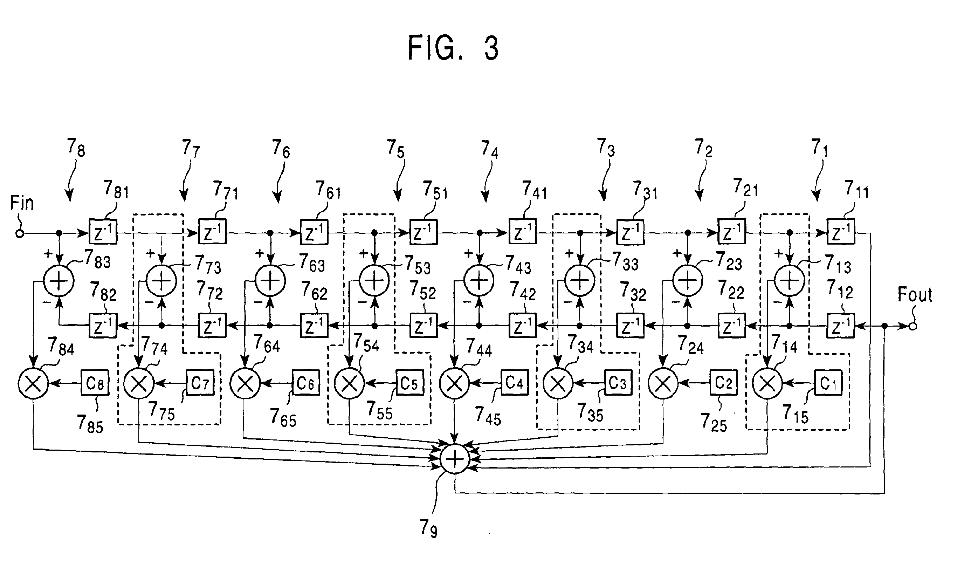

Fig. 3 is a circuit diagram showing a first construction example of the IIR digital filter 7 used with the digital quadrature signal detector 2 shown in Fig. 1.

Referring to Fig. 3, the IIR digital filter 7 according to the first construction example is equipped with a filter input terminal Fin, a filter output terminal Fout, eight signal processors $7_1$ through $7_8$ connected in concatenation from the output end to the input end, and a common adder $7_9$. In this case, the signal processors $7_1$ through $7_8$ individually include first delayers $7_{11}$ through $7_{81}$, second delayers $7_{12}$ through $7_{82}$, adders $7_{13}$ through $7_{83}$, multipliers $7_{14}$ through $7_{84}$, and multiplication coefficient generators $7_{15}$ through $7_{85}$. In the individual signal processors $7_1$ through $7_8$, the individual first delayers $7_{11}$ through $7_{81}$, second delayers $7_{12}$ through $7_{82}$, adders $7_{13}$ through $7_{83}$, multipliers $7_{14}$ through $7_{84}$, and multiplication coefficient generators $7_{15}$ through $7_{85}$ are interconnected as shown in Fig. 3.

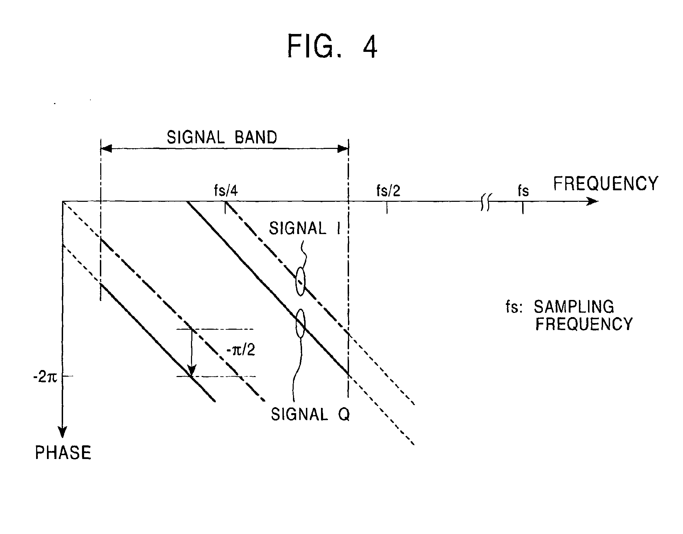

Fig. 4 is a schematic diagram illustrating the changes in the output phase of the IIR digital filter 7 having an all pass characteristic, the changes in the output phase of the DL 8 being also shown.

Referring to Fig. 4, the axis of ordinate indicates the phase, while the axis of abscissa indicates frequency. The solid lines indicate the changes in the phase of the IIR digital filter 7, and the one-dot chain lines indicate the changes in the phase of the DL 8.

As shown in Fig. 4, in the signal band (the range defined by the dotted lines) having its center set at a frequency fs/4, which is a quarter of the sampling frequency fs, the phase value of the DL 8 linearly changes from a lower limit frequency value toward an upper limit frequency value in the signal band. When the phase value reaches $-2\pi$, a jump to a phase value 0 takes place, and the phase value linearly changes again toward the upper limit frequency value. Similarly, the phase value of the IIR digital filter 7 also linearly changes at the same phase gradient as that of the DL 8 from the lower limit frequency value toward the upper limit frequency value of the signal band. When the phase value reaches $-2\pi$, a jump to a phase value 0 takes place, and the phase value linearly changes again toward the upper limit frequency value. Thus, the phase difference between the phase value of the IIR digital filter 7 and the phase value of the DL 8 is always maintained at $-(\pi/2)$, i.e., -90 degrees.

In this case, the ratio of a phase change to a frequency change is the phase gradient, and the phase gradient is defined by the number of phase changes that take place at every $-2\pi$ in the frequency range from 0 to fs. For example, if the cumulative phase obtained from the frequency range from 0 to fs is $-6\pi$, then the phase gradient is 3.

From its definition, the phase gradient is also a group delay time on the basis of sampling time. For instance, if the phase gradient is 3, then the group delay is 3 clocks.

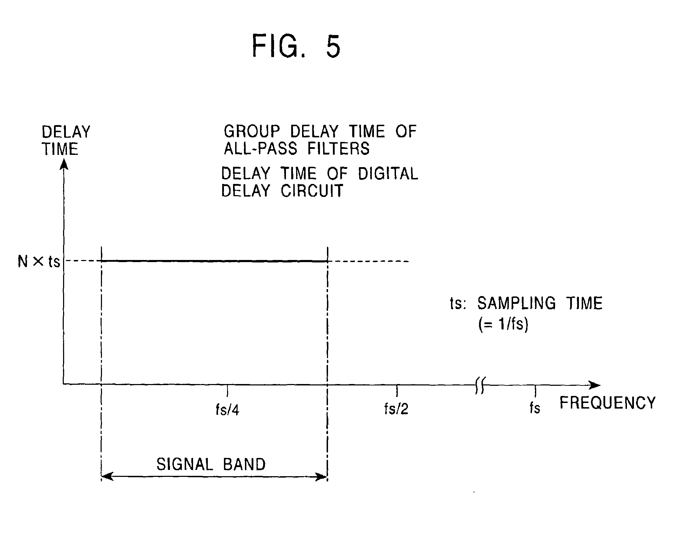

Fig. 5 is a schematic representation illustrating the group delay characteristic of the IIR digital filter 7, the delay characteristic of the DL 8 being also shown.

Referring to Fig. 5, the axis of ordinate indicates delay time, while the axis of abscissa indicates frequency. The solid lines indicate the group delay characteristics of the IIR digital filter 7 and the DL 8.

As shown in Fig. 5, in the signal band (the range defined by the dotted lines) having its center set at a frequency fs/4, which is a quarter of the sampling frequency fs, the group delay characteristic of the IIR digital filter 7 and the group delay time of the DL 8 both exhibit the same fixed value, N x ts (where N denotes a phase gradient number, and ts denotes a sampling time).

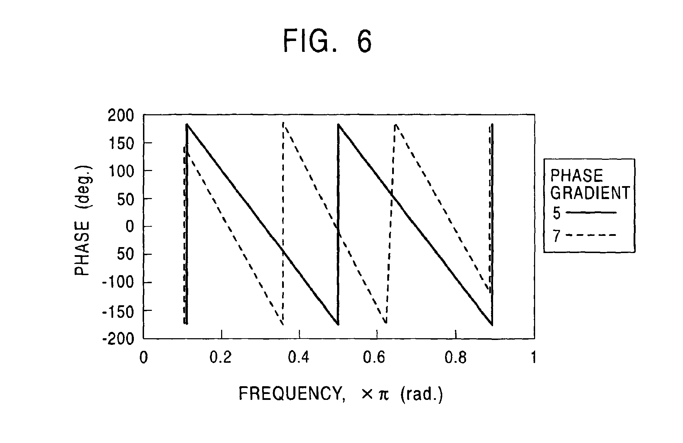

Fig. 6 is a characteristic diagram showing changes in the phase that occur when the phase gradient number generated in the frequency band in the IIR digital filter 7 is changed.

In Fig. 6, the axis of ordinate indicates the phase represented in degrees, while the axis of abscissa indicates frequency represented in radian ($2\pi$ radians corresponding to sampling frequency). The solid line denotes the changes in phase when the phase gradient number of the IIR digital filter 7 is set to 5, while the dashed line denotes the changes in phase when the phase gradient number of the IIR digital filter 7 is set to 7.

As shown in Fig. 6, if appropriate delay constants of the first delayer and the second delayer constituting the IIR digital filter 7 and appropriate coefficients of the multiplication coefficient generators are selected, then the phase of the IIR digital filter 7 linearly changes in the frequency band ($0.1\pi$ through $0.9\pi$ radians) of digital signals so that the phase gradient number is 5 or 7 over the full frequency band (0 through $2\pi$ radians).

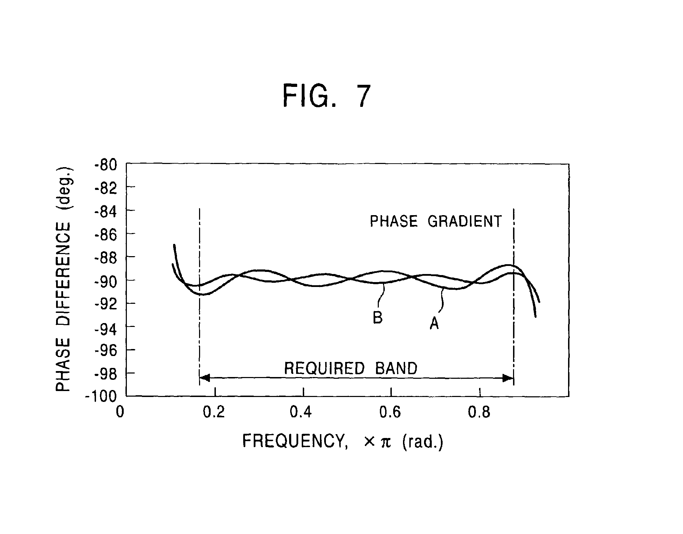

Fig. 7 is a characteristic diagram showing the changes in phase difference between the phase of the IIR digital filter 7 and the phase of the DL 8 in the signal band of the IIR digital filter 7 shown in Fig. 6.

Referring to Fig. 7, the axis of ordinate indicates phase difference in degrees, while the axis of abscissa indicates frequency in radian. Curve A represents changes in phase difference that are observed when the phase gradient number of the IIR digital filter 7 is set to 5, while curve B represents changes in phase difference that are observed when the phase gradient number of the IIR digital filter 7 is set to 7.

As indicated by curve A and curve B shown in Fig. 7, in the frequency band (0.1π through 0.9π radians) of digital signals, it can be seen that the phase difference of the IIR digital filter 7 lies in the vicinity of -90 degrees although there are changes in the phase difference observed at 5 or 7.

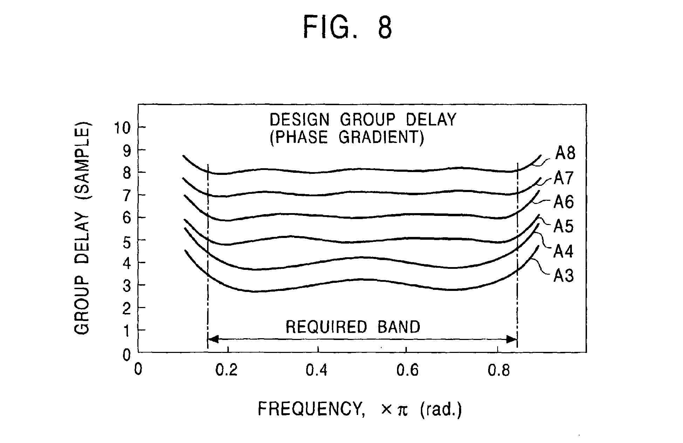

Fig. 8 is a characteristic diagram showing changes in group delay obtained when the phase gradient number is used as a parameter in the IIR digital filter 7.

In Fig. 8, the axis of ordinate indicates group delay represented on the basis of the number of samples, while the axis of abscissa indicates frequency represented in radians. Curves A3 through A8 indicate changes in group delay that are observed when the phase gradient number of the IIR digital filter 7 is set to 3 to 8.

As indicated by curves A3 through A8 shown in Fig. 8, in the frequency band (0.1π through 0.9π radians) of digital signals, it can be seen that the changes in the group delay of the IIR digital filter 7 stay within a limited range as a whole, although the changes gradually grow smaller as the phase gradient number increases from 3 to 8.

Thus, according to the IIR digital filter 7 of the first construction example, if appropriate delay constants of the first delayers and the second delayers and appropriate coefficients of multiplication coefficient generators are selected so that the phase gradient number of the IIR digital filter 7 becomes, for example, 3 or more, then the phase difference between signal Q output from the IIR digital filter 7 and signal I output from the DL 8 can be controlled substantially to 90 degrees in the frequency band of digital signals. Moreover, the group delays of signal Q and signal I can be made practically the same. Furthermore, since the IIR digital filter 7 is used to obtain signal Q, the number of components can be reduced, so that the circuit configuration will be simpler, permitting a smaller occupying volume and reduced power consumption to be achieved, as compared with a known circuit of the same type.

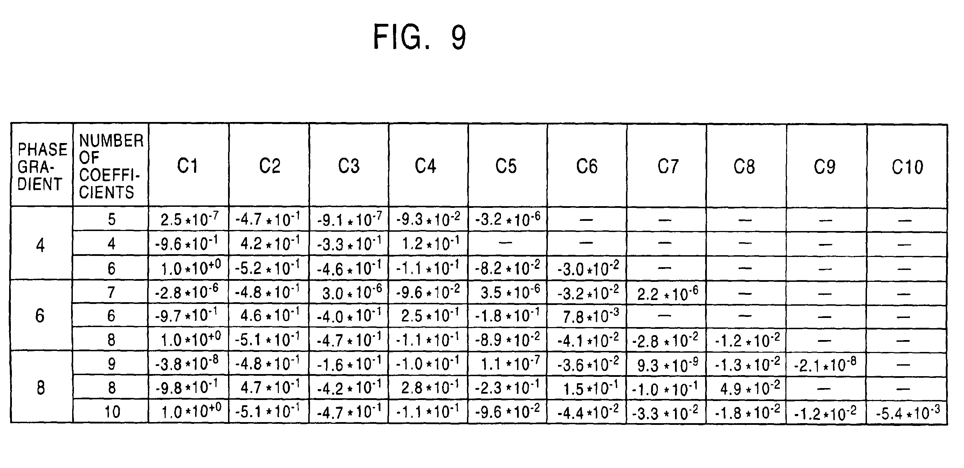

Fig. 9 is a table showing exemplary coefficient values set at the multiplication coefficient generator obtained when a phase gradient number to be generated and the number of disposed stages of signal processors are decided in the IIR digital filter 7.

Referring to Fig. 9, the leftmost column shows the phase gradient number (denoted as "phase gradient" in the table), the next column shows the number of disposed stages of the signal processors (denoted as "number of coefficients" in the table), and the further next column shows coefficient values set at the multiplication coefficient generator. The table shows coefficients C1, C2, ... ...,C8 shown in the multiplication coefficient generator of Fig. 3 in addition to C9 and C10, which are the coefficients of the multiplication coefficient generators of the ninth and tenth signal processor stages, which are not shown in Fig. 3.

As shown in Fig. 9, in the configuration example of the uppermost stage, when the phase gradient is 4, and the number of coefficients is 5, then coefficient C1 is set to $2.5 \times 10^{-7}$, coefficient C2 is set to $-0.4 \times 10^{-1}$, coefficient C3 is set to $-9.1 \times 10^{-7}$, coefficient C4 is set to $-9.3 \times 10^{-2}$, and coefficient C5 is set to $-3.2 \times 10^{-6}$, respectively. Similarly, in the configuration examples of the second stage and after, the required numbers of coefficients C1 to C10 are set to the values shown in the table, the required numbers depending upon the phase gradient and the number of coefficients.

Referring to the coefficient values of coefficients C1 through C10 shown in Fig. 9, when the phase gradient is 4 and the number of coefficients is 5, when the phase gradient is 6 and the number of coefficients is 7, and when the phase gradient is 8 and the number of coefficients is 9, the coefficient values with exponents of odd-numbered coefficients C1, C3, C5, C7 and C9 are set to $10^{-6}$, $10^{-7}$, $10^{-8}$, and $10^{-9}$. If the number of significant digits is five, then the coefficient values including these numerical values indicate substantially zero.

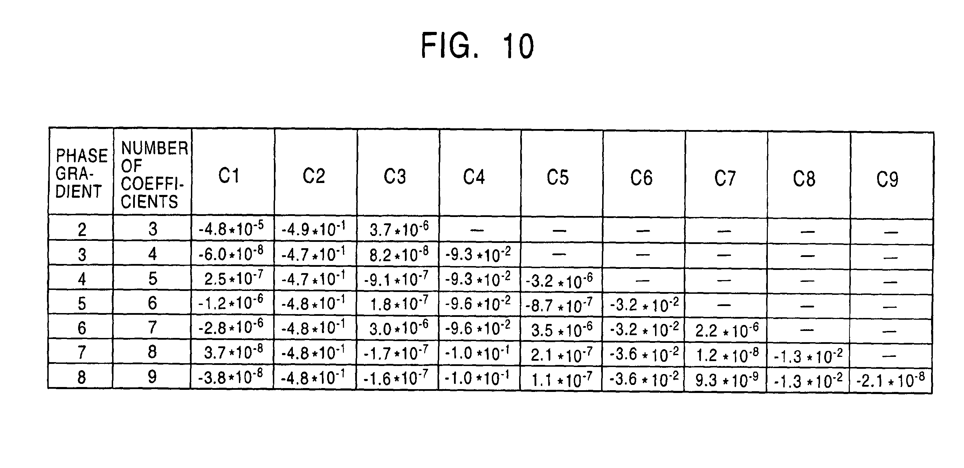

Fig. 10 is a table showing a further generalized relationship among the phase gradients, the number of coefficients, and the coefficient values of the coefficients shown in Fig. 9.

Referring to Fig. 10, the leftmost column shows phase gradients, the next column shows the number of coefficients, and the further next column shows coefficients C1, C2, ... ...,C9. The table shows the coefficient values of C1, C2, ... ...,C9 in the combinations of phase gradients and the numbers of coefficients at which the number of coefficients is n+1 when the phase gradient is n.

As shown in Fig. 10, in a combination in which the phase gradient is m and the number of coefficients is m+1, or in combinations in which the phase gradients are 2 to 8 and the corresponding numbers of coefficients are 3 to 9, the coefficient values, including exponents, of all the odd-numbered coefficients C1, C3, C5, C7, and C9 are set to $10^{-5}$, $10^{-6}$, $10^{-7}$, $10^{-8}$, and $10^{-9}$. The coefficient values including these numerical values indicate substantially zero.

With such a relationship between the phase gradients and the numbers of coefficients, if the coefficient of the multiplication coefficient generator is zero, then the multiplication output data of the multiplier for multiplying the coefficient zero output by the multiplication coefficient generator becomes zero, and the output data of the adder supplied to the multiplier is no longer unnecessary. Therefore, it is not necessary to provide adders $7_{13}$, $7_{33}$, $7_{53}$, $7_{73}$ and so on, multipliers $7_{14}$, $7_{34}$, $7_{54}$, $7_{74}$, and so on, and multiplication coefficient generators $7_{15}$, and $7_{35,}$ $7_{55}$, $7_{75}$ and so on in the signal processing stages having the multiplication coefficient generators whose coefficients become zero, namely, odd-numbered signal processing stages $7_1$, $7_3$, $7_5$, $7_7$, and so on, making it possible to omit them.

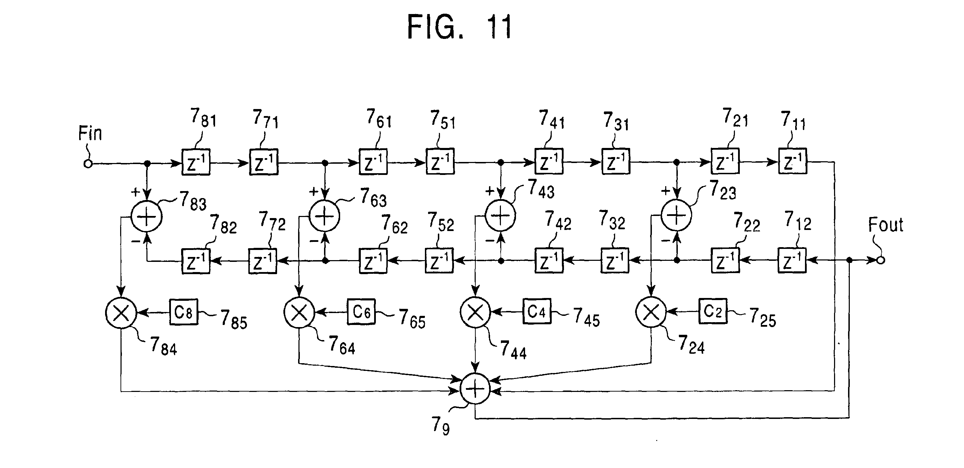

Fig. 11 is a circuit diagram showing a second configuration example of the IIR digital filter 7 used with the digital quadrature signal detector 2 shown in Fig. 1. In this example, the phase gradient is 7, and the number of coefficients is 8, and the adders $7_{13}$, $7_{33}$, $7_{53}$, $7_{73}$, multipliers $7_{14}$, $7_{34}$, $7_{54}$, $7_{74}$, and multiplication coefficient generators $7_{15}$, $7_{35}$, $7_{55}$, $7_{75}$ in the odd-numbered signal processing stages $7_1$, $7_3$, $7_5$, $7_7$ have been omitted.

In Fig. 11, the same components as those shown in Fig. 3 are assigned the same reference numerals.

The IIR digital filter 7 according to the second configuration example shown in Fig. 11 (hereinafter referred to as "the second configuration example") will be compared with the IIR digital filter 7 according to the first configuration example shown in Fig. 3 (hereinafter referred to as "the first configuration example"). In the second configuration example, the components enclosed by the dashed lines shown in Fig. 3, namely, the adders $7_{13}$, $7_{33}$, $7_{53}$, $7_{73}$, multipliers $7_{14}$, $7_{34}$, $7_{54}$, $7_{74}$, and multiplication coefficient generators $7_{15}$, $7_{35}$, $7_{55}$, $7_{75}$ in the odd-numbered signal processing stages $7_1$, $7_3$, $7_5$, $7_7$ in the first configuration example (the stages enclosed by the dashed lines in Fig. 3), have been omitted. The rest of the configuration has no structural difference between the second configuration example and the first configuration example. Hence, the same explanation will not be repeated for the configuration of the IIR digital filter 7 according to the second configuration example.

The operation of the IIR digital filter 7 according to the second configuration example is practically identical to that of the IIR digital filter 7 according to the first configuration example corresponding thereto. Furthermore, the changes in the phase and the changes in the group delay in the IIR digital filter 7 according to the second configuration example are almost identical to the changes in the phase and the changes in the group delay in the IIR digital filter 7 according to the first configuration example. Hence, the same explanation will not be repeated for the operation of the IIR digital filter 7 according to the second configuration example.

As compared with the IIR digital filter 7 according to the first configuration example, the IIR digital filter 7 according to the second configuration example has omitted the adders $7_{13}$, $7_{33}$, $7_{53}$, $7_{73}$ and so on, multipliers $7_{14}$, $7_{34}$, $7_{54}$, $7_{74}$ and so on, and multiplication coefficient generators $7_{15}$, $7_{35}$, $7_{55}$, $7_{75}$ and so on in the odd-numbered signal processing stages $7_1$, $7_3$, $7_5$, $7_7$ and so on. Hence, the number of components can be further reduced, permitting an even simpler circuit configuration to be accomplished with resultant smaller occupying volume and reduced power consumption.

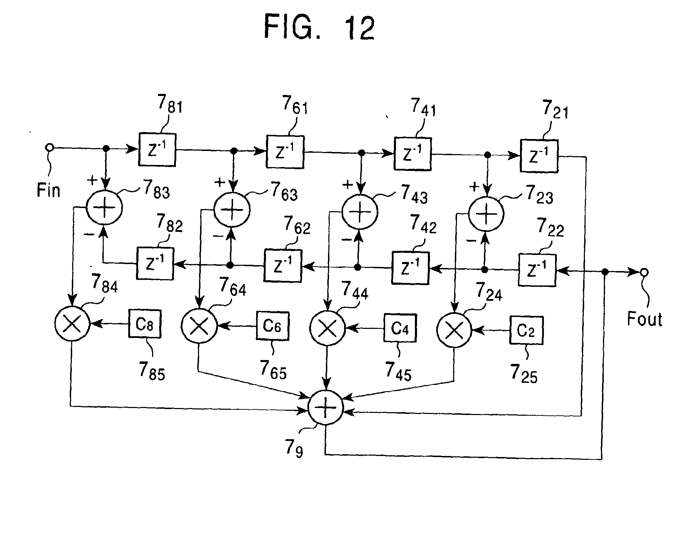

Fig. 12 is a circuit diagram showing a third configuration example of the IIR digital filter 7 used with the digital quadrature signal detector 2 shown in Fig. 1. In this example, the phase gradient is 7, and the number of coefficients is 8, and the operating frequency of the IIR digital filter 7 is set at a frequency fs/2, which is half the sampling frequency fs of digital signals, to decimate filter outputs by degree 2.

In Fig. 12, the same components as those shown in Fig. 3 are assigned the same reference numerals.

The IIR digital filter 7 according to a third configuration example shown in Fig. 12 (hereinafter referred to as "the third configuration example") will be compared with the IIR digital filter 7 according to the second configuration example shown in Fig. 11 (hereinafter referred to as "the second configuration example"). The third configuration example has omitted first delayers $7_{11}$, $7_{31}$, $7_{51}$, $_{71}$ and second delayers $7_{12}$, $7_{32}$, $7_{52}$, $7_{72}$, together with the adders $7_{13}$, $7_{33}$, $7_{53}$, $7_{73}$, multipliers $7_{14}$, $7_{34}$, $7_{54}$, $7_{74}$, and multiplication coefficient generators $7_{15}$, $7_{35}$, $7_{55}$, $7_{75}$ in the odd-numbered signal processing stages $7_1$, $7_3$, $7_5$, $7_7$ of the second configuration example. The rest of the configuration has no structural difference between the third configuration example and the second configuration example. Hence, the same explanation will not be repeated for the configuration of the IIR digital filter 7 according to the third configuration example.

The operation of the IIR digital filter 7 according to the third configuration example is practically identical to that of the IIR digital filter 7 according to the second configuration example, except that the operation frequency is the half. Furthermore, the changes in the phase and the changes in the group delay in the IIR digital filter 7 according to the third configuration example are almost identical to the corresponding changes in the phase and in the group delay in the IIR digital filter 7 according to the second configuration example. Hence, the same explanation will not be repeated for the operation of the IIR digital filter 7 according to the third configuration example.

As compared with the IIR digital filter 7 according to the second configuration example, the IIR digital filter 7 according to the third configuration example makes it possible to omit the first delayers $7_{11}$, $7_{31}$, $7_{51}$, $7_{71}$ and so on and the second delayers $7_{12}$, $7_{32}$, $7_{52}$, $7_{72}$ and so on in addition to the adders $7_{13}$, $7_{33}$, $7_{53}$, $7_{73}$ and so on, multipliers $7_{14}$, $7_{34}$, $7_{54}$, $7_{74}$ and so on, and multiplication coefficient generators $7_{15}$, $7_{35}$, $7_{55}$, $7_{75}$ and so on in the odd-numbered signal processing stages $7_1$, $7_3$, $7_5$, $7_7$ and so on. Hence, the number of components can be markedly reduced, permitting an even simpler circuit configuration to be accomplished with resultant even smaller occupying volume and significantly reduced power consumption. The further reduced occupying volume allows even lower manufacturing cost to be achieved. Moreover, according to the third configuration example, the operating frequency is half that in the first and second configuration examples, so that the power consumption will be considerably reduced accordingly.

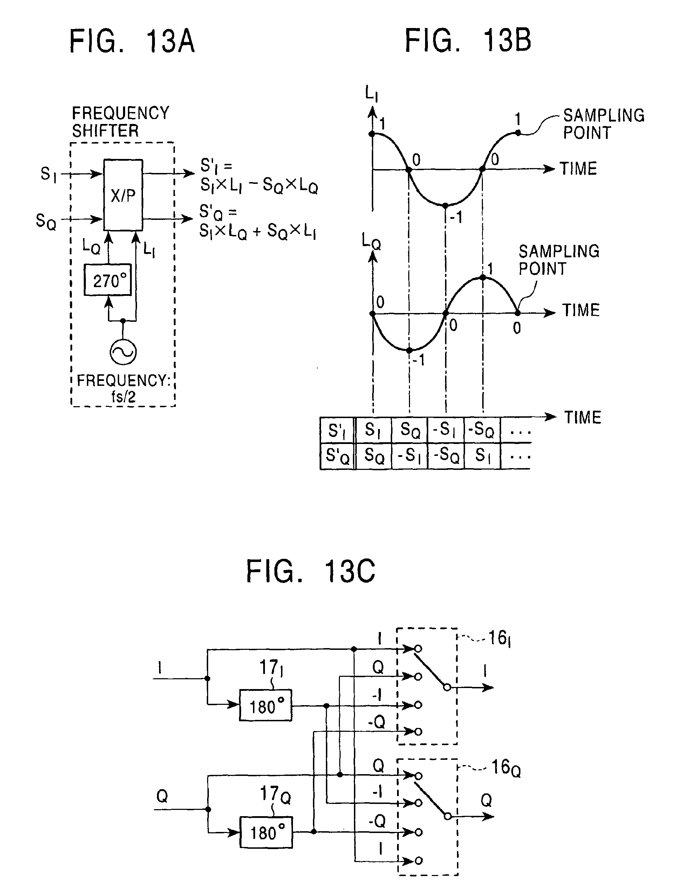

Figs. 13A through 13C are schematic representations illustrating specific details of the complex multiplier 11 of the frequency shifter 3 used with the OFDM signal demodulator circuit shown in Fig. 1. Fig. 13A shows input/output signals, Fig. 13B shows the relationship between the input/output signals and sampling points, and Fig. 13C shows an equivalent circuit.

Fig. 13A shows that, when an in-phase signal $S_I$, a quadrature signal $S_Q$, a multiplication signal $L_I$, and a quadrature multiplication signal $L_Q$ are supplied to the complex multiplier 11, the processing for obtaining a complex sum of products of the signals $S_I$, $S_Q$, $L_I$, and $L_Q$ is carried out to output an in-phase signal $S'_I$ and a quadrature signal $S'_Q$. The output in-phase signal $S'_I$ and a quadrature signal $S'_Q$ are formed of the following signal components:

$$S'_I = S_I \times L_I - S_Q \times L_Q, \quad S'_Q = S_I \times L_Q + S_Q \times L_I$$

Fig. 13B shows the values of the in-phase signal $S'_I$ and the quadrature signal $S'_Q$ obtained when sampling is carried out when the amplitudes of the multiplication signal $L_I$ and the quadrature multiplication signal $L_Q$ reach positive and negative peak values and a zero value in the complex multiplier 11. Each time a sampling point is reached, $S_I$, $S_Q$, $-S_I$, $-S_Q$, and so on are output in order as the in-phase signal $S'_I$. Similarly, each time a sampling point is reached, $S_Q$, $-S_I$, $-S_Q$, $S_I$, and so on are output in order as the quadrature signal $S'_Q$.

Fig. 13C shows an equivalent circuit exhibited by the complex multiplier 11 when sampling is carried out under the sampling condition shown in Fig. 13B. The equivalent circuit is constructed of two switches $16_I$, $16_Q$, each having one circuit with four contacts, and two phase inverters $17_I$, $17_Q$. The switches $16_I$, $16_Q$ and the phase inverters $17_I$, $17_Q$ are interconnected as illustrated in Fig. 13C.

As is obvious from Fig. 13C, the equivalent circuit operates such that, when first sampling is carried out, movable contacts of the switches $16_I$, $16_Q$ are connected to the first fixed contact from the top, causing the in-phase signal $S_I$ to be output as the in-phase signal $S'_I$ and the quadrature signal $S_Q$ to be output as the quadrature signal $S'_Q$. When the next sampling is carried out, the movable contacts of the switches $16_I$, $16_Q$ are connected to the second fixed contact from the top, causing the quadrature signal $S_Q$ to be output as the in-phase signal $S'_I$ and the in-phase signal $-S_I$, which has been phase-inverted by the phase inverter $17_I$, to be output as the quadrature signal $S'_Q$. When the subsequent sampling is carried out, the movable contacts of the switches $16_I$, $16_Q$ are connected to the third fixed contact from the top, causing the in-phase signal $-S_I$, which has been phase-inverted by the phase inverter $17_I$, to be output as the in-phase signal $S'_I$, and the quadrature signal $-S_Q$, which has been phase-inverted by the phase inverter $17_Q$, to be output as the quadrature signal $S'_Q$. When the subsequent sampling is carried out, the movable contacts of the switches $16_I$, $16_Q$ are connected to the fourth fixed contact from the top, causing the quadrature signal $-S_Q$, which has been phase-inverted by the phase inverter $17_Q$, to be output as the in-phase signal $S'_I$, and the in-phase signal $S_I$ to be output as the quadrature signal $S'_Q$. When the further next sampling is carried out, the movable contacts of the switches $16_I$, $16_Q$ are connected to the first fixed contact from the top, causing the in-phase signal $S'_I$ and the quadrature signal $S'_Q$ mentioned above to be output. Thereafter, the operation is repeatedly performed each time a point for performing the sampling is reached.

Thus, the construction of the complex multiplier 11 can be markedly simplified and the number of its components can be significantly reduced by setting the frequencies of the multiplication signal $L_I$ and the quadrature multiplication signal $L_Q$ at fs/2 in relation to the sampling frequency 2fs of the in-phase signal $S_I$ and the quadrature signal $S_Q$, and by setting the sampling points at the positive and negative peak values and zero values of the multiplication signal $L_I$ and the quadrature multiplication signal $L_Q$.

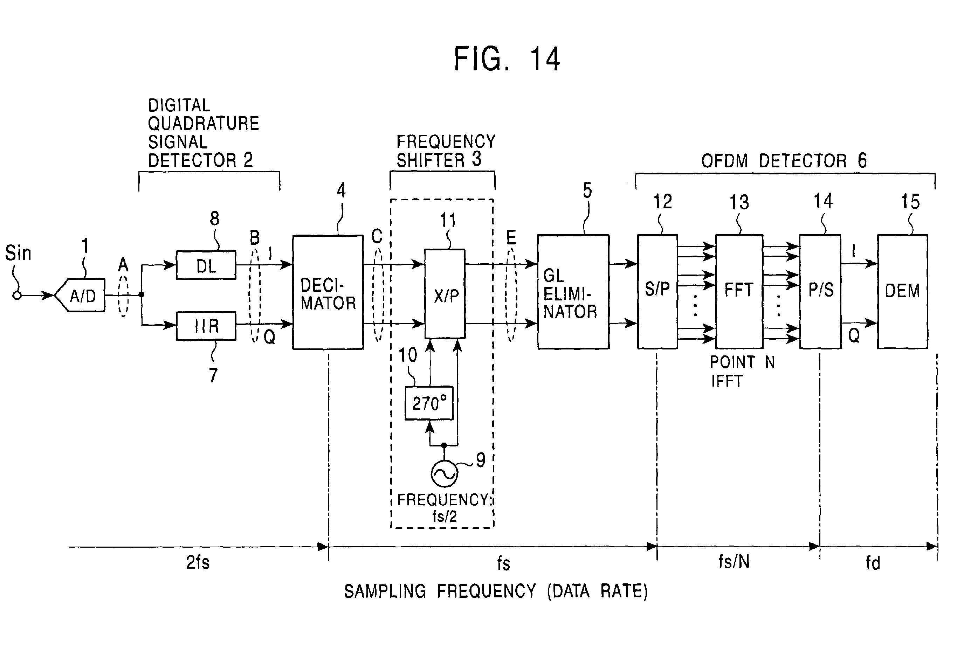

Fig. 14 is a block diagram showing the configuration of an essential section of an OFDM signal demodulator circuit according to a second embodiment of the present invention.

In Fig. 14, the same components as those shown in Fig. 1 are assigned the same reference numerals.

The OFDM signal demodulator circuit according to the second embodiment (hereinafter referred to as "the second embodiment") shown in Fig. 14 and the OFDM signal demodulator circuit according to the first embodiment (hereinafter referred to as "the first embodiment") shown in Fig. 1 differ only in the connected location of the decimator 4. The decimator 4 is connected to the output end of the frequency shifter 3 in the first embodiment, while it is connected to the input end of the frequency shifter 3 in the second embodiment. Except for this point, there is no other structural difference between the first embodiment and the second embodiment.

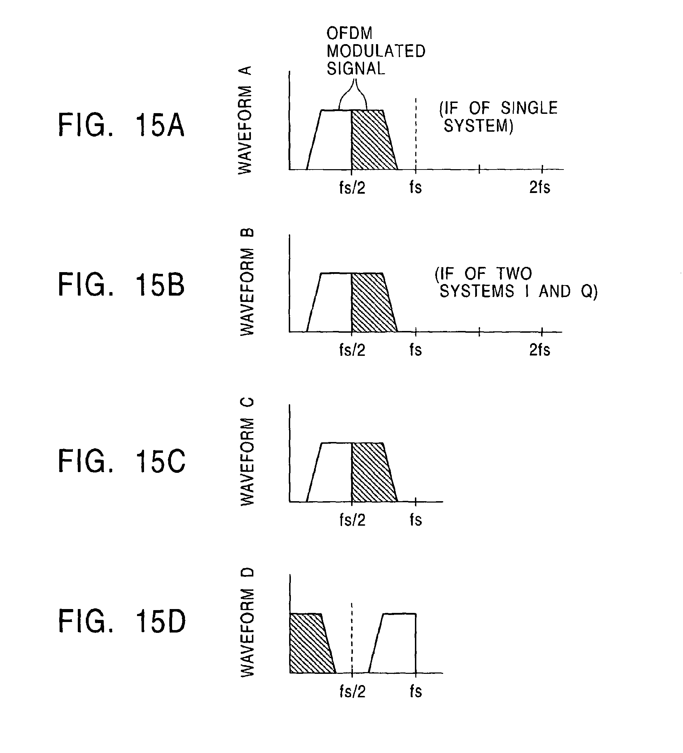

Figs. 15A through 15D show the signal spectra (signal waveforms) obtained at components of the second embodiment shown in Fig. 14. Fig. 15A shows digital signal waveform A output from the analog/digital converter 1, Fig. 15B shows waveform B of signal I and signal Q output from the digital quadrature signal detector 2, Fig. 15C shows waveform D of signal I and signal Q output from the decimator 4, and Fig. 15D shows waveform E of signal I and signal Q output from the frequency shifter 3.

Referring to Figs. 15A and 15B, digital signal waveform A output from the analog/digital converter 1 and waveform B of signal I and signal Q output from the digital quadrature signal detector 2 in the second embodiment are the same as corresponding digital signal waveform A and waveform B of signal I and signal Q in the first embodiment shown in Figs. 2A and 2B. Referring now to Fig. 15C, waveform D of signal I and signal Q output from the decimator 4 in the second embodiment is obtained by decimating, with the degree 2, signal I and signal Q of the intermediate frequency by the decimator 4, so that waveform D is identical to digital signal waveform A and waveform B of signal I and signal Q shown in Figs. 15A and 15B, while it differs from waveform C of signal I and signal Q output from the frequency shifter 3 shown in Fig. 2C. Referring to Fig. 15D, waveform E of signal I and signal Q output from the frequency shifter 3 in the second embodiment passes through the decimator 4 and the frequency shifter 3, as in the first embodiment, so that waveform E is the same as waveform D of signal I and signal Q output from the decimator 4 shown in Fig. 2D.

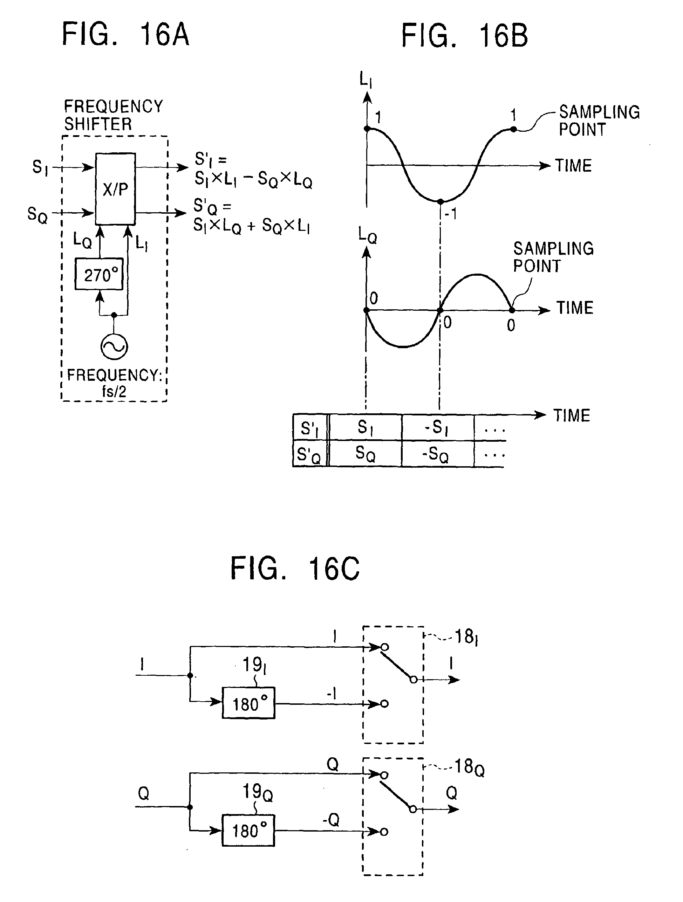

Figs. 16A through 16C are schematic representations illustrating specific details of the complex multiplier 11 of the frequency shifter 3 used with the OFDM signal demodulator circuit shown in Fig. 14. Fig. 16A shows input/output signals, Fig. 16B shows the relationship between the input/output signals and sampling points, and Fig. 16C shows an equivalent circuit.

Fig. 16A illustrates the relationship among the in-phase signal $S_I$ and the quadrature signal $S_Q$, the multiplication signal $L_I$ and the quadrature multiplication signal $L_Q$, and the in-phase signal $S'_I$ and the quadrature signal $S'_Q$ that are input to or output from the complex multiplier 11. Fig. 16A corresponds to Fig. 13A described above. In this example, the decimator 4 is located before, so that the sampling frequency fs of the in-phase signal $S_I$ and the quadrature signal $S_Q$ is reduced in half. Hence, the quadrature signal $S_Q$ in the in-phase signal $S'_I$ and the in-phase signal $S_I$ in the quadrature signal $S'_Q$ can be reduced to zero, as it will be discussed hereinafter, the in-phase signal $S'_I$ and the quadrature signal $S'_Q$ being expressed as shown below:

$$S'_I = S_I \times L_I, \quad S'_Q = S_Q \times L_I$$

Fig. 16B shows the values of the in-phase signal $S'_I$ and the quadrature signal $S'_Q$ when sampling is carried out when the amplitude of the multiplication signal $L_I$ reach positive and negative peak values and when sampling is carried out when the amplitude of the quadrature multiplication signal $L_Q$ reaches a zero value in the complex multiplier 11. Each time a sampling point is reached, $S_I$, $-S_I$, and so on are output in order as the in-phase signal $S'_I$. Similarly, each time a sampling point is reached, $S_Q$, $-S_Q$ and so on are output in order as the quadrature signal $S'_Q$.

Fig. 16C shows an equivalent circuit exhibited by the complex multiplier 11 when sampling is carried out under the sampling condition shown in Fig. 16B. The equivalent circuit is constructed of two switches $18_I$, $18_Q$, each having one circuit with two contacts, and two phase inverters $19_I$, $19_Q$. The switches $18_I$, $18_Q$ and the phase inverters $19_I$, $19_Q$ are interconnected as illustrated in Fig. 16C.

As is obvious from Fig. 16C, the equivalent circuit operates such that, when first sampling is carried out, movable contacts of the switches $18_I$, $18_Q$ are connected to an upper fixed contact, causing the in-phase signal $S_I$ to be output as the in-phase signal $S'_I$ and the quadrature signal $S_Q$ to be output as the quadrature signal $S'_Q$. When the next sampling is carried out, the movable contacts of the switches $18_I$, $18_Q$ are connected to a lower fixed contact, causing the in-phase signal $-S_I$, which has been phase-inverted by the phase inverter $19_I$, to be output as the in-phase signal $S'_I$, and the quadrature signal $-S_Q$, which has been phase-inverted by the phase inverter $19_Q$, to be output as the quadrature signal $S'_Q$. When the subsequent sampling is carried out, the movable contacts of the switches $18_I$, $18_Q$ are connected to the upper fixed contact again, causing the in-phase signal $S_I$ to be output as the in-phase signal $S'_I$, and the quadrature signal $S_Q$ to be output as the quadrature signal $S'_Q$. Thereafter, the operation is repeatedly performed each time a point for performing the sampling is reached.

Thus, in the frequency shifter 3 according to the second embodiment, the construction of the complex multiplier 11 can be made further markedly simpler than that of the complex multiplier 11 according to the first embodiment so as to significantly reduce the number of its components and to reduce the power consumption of the complex multiplier 11 in half by setting the frequencies of the multiplication signal $L_I$ and the quadrature multiplication signal $L_Q$ at fs/2 in relation to the sampling frequency fs of the in-phase signal $S_I$ and the quadrature signal $S_Q$ supplied to the complex multiplier 11, and by setting the sampling points at the positive and negative peak values of the multiplication signal $L_I$ and the zero value of the quadrature multiplication signal $L_Q$.

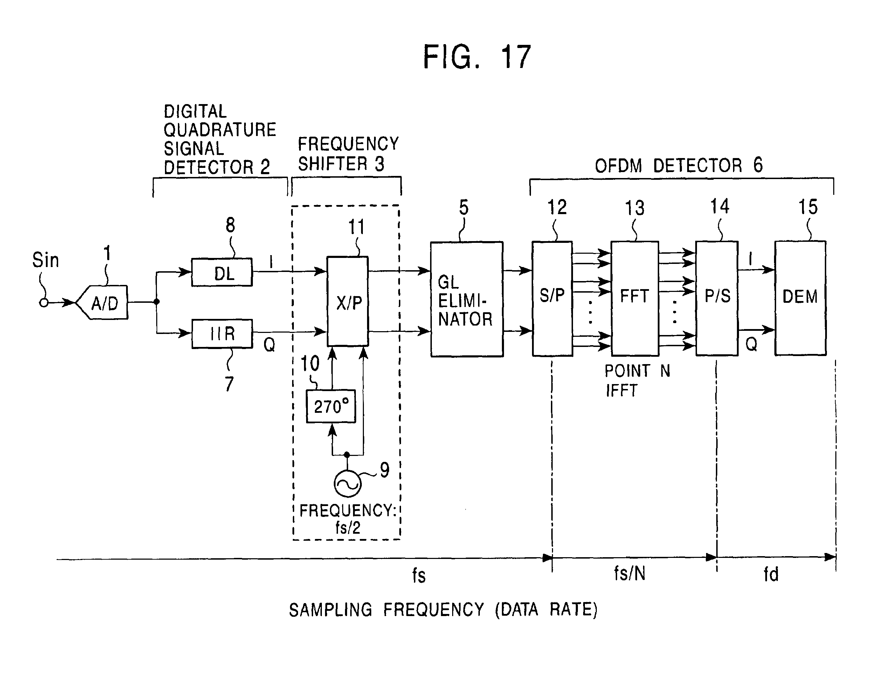

Fig. 17 is a block diagram showing the configuration of an essential section of an OFDM signal demodulator circuit according to a third embodiment of the present invention.

In Fig. 17, the same components as those shown in Fig. 1 are assigned the same reference numerals.

The OFDM signal demodulator circuit according to the third embodiment (hereinafter referred to as "the third embodiment") shown in Fig. 17 and the OFDM signal demodulator circuit according to the first embodiment (hereinafter referred to as "the first embodiment") shown in Fig. 1 differ only in that the decimator 4 is connected to the output end of the frequency shifter 3 in the first embodiment, while no decimator 4 is connected to frequency shifter 3 in the third embodiment. Except for this point, there is no other structural difference between the first embodiment and the third embodiment.

In this case, the frequency shifter 3 described in conjunction with Figs. 14A through 14C is used as the frequency shifter 3 in the third embodiment since the sampling frequency of signal I and signal Q supplied to the complex multiplier 11 is 2fs.

Since the third embodiment is not provided with the decimator 4, the number of the components can be reduced accordingly, as compared with the first embodiment and the second embodiment.

In the second embodiment and the third embodiment, the digital all pass filter constituting the digital quadrature signal detector 2 uses the same IIR digital filter used in the first embodiment. Therefore, the number of components can be reduced, and a reduced occupying volume and reduced power consumption can be achieved by the simpler circuit configuration, as in the case of the first embodiment.

**Claims**

1. An orthogonal frequency division multiplex signal demodulator circuit, comprising:

   an analog/digital converter (1) for carrying out analog/digital conversion at a sampling frequency on a received signal whose central frequency is non-zero, and for outputting a digital signal;
   a digital quadrature signal detector (2) comprising a digital signal delay circuit (8) for delaying the digital signal to generate an in-phase signal, and a digital all pass filter (7) for shifting the phase of the digital signal by 90 degrees to generate a quadrature signal;
   a frequency shifter (3) for shifting the frequencies of the in-phase signal and the quadrature signal to turn them into baseband signals having their central frequencies set at zero; and
   an orthogonal frequency division multiplex detector (6) constructed of a fast Fourier transformer (13) for carrying out fast Fourier transformation on the baseband signals and a digital demodulator (15) for demodulating the digital signal that has been subjected to the fast Fourier transformation,

   **characterized in that** the digital all pass filter is an infinite impulse response digital filter having a predetermined group delay characteristic, and
   the digital signal delay circuit has a signal delay amount equal to the group delay amount of the digital all pass filter.

2. The orthogonal frequency division multiplex signal demodulator circuit according to Claim 1, further comprising a signal decimator (4) for decimating the in-phase signal and the quadrature signal by a degree 2 the decimator being connected to an output end of the frequency shifter.

3. The orthogonal frequency division multiplex signal demodulator circuit according to Claim 1, further comprising a signal decimator for decimating the baseband signals having their central frequencies at zero by the degree 2, the decimator being connected to an input end of the frequency shifter.

4. The orthogonal frequency division multiplex signal demodulator circuit according to Claim 2, wherein the frequency shifter comprises:

   an oscillator (9) for generating a multiplication signal of a frequency that is half a sampling frequency;
   a phase shifter (10) for producing a quadrature multiplication signal from the multiplication signal; and
   a complex multiplier (11) for producing signals comprised of complex sum of products of the multiplication signal and the quadrature multiplication signal for the in-phase signal and the quadrature signal, and for outputting baseband signals, one cycle of which consisting of 4 sampling points.

5. The orthogonal frequency division multiplex signal demodulator circuit according to Claim 3, wherein the frequency shifter comprises:

   an oscillator for generating a multiplication signal of a frequency that is half a sampling frequency;
   a phase shifter for producing a quadrature multiplication signal from the multiplication signal; and
   a complex multiplier for producing signals comprised of complex sum of products of the multiplication signal and the quadrature multiplication signal for the in-phase signal and the quadrature signal, and for outputting baseband signals, one cycle of which consisting of 2 sampling points.

6. The orthogonal frequency division multiplex signal demodulator circuit according to Claim 1, wherein
   the infinite impulse response digital filter comprises an arbitrary integer n of three or more stages of signal processors ($7_1$ to $7_8$), at least the processors of the even-numbered stages being connected in concatenation and each having a first delayer ($7_{11}$ to $7_{81}$), a second delayer ($7_{12}$ to $7_{82}$), an adder ($7_{13}$ to $7_{83}$), a multiplier ($7_{14}$ to $7_{84}$), and a

multiplication coefficient generator ($7_{15}$ to $7_{85}$), and
the coefficients of all the multiplication coefficient generators of the signal processors are set such that the phase gradient number generated in a signal band having its center set at a quarter of the sampling frequency is n-1.

7. The orthogonal frequency division multiplex signal demodulator circuit according to Claim 6, wherein in the n stages of signal processors, the signal processor of an odd-numbered stage from the output end comprises only a first delayer and a second delayer.

8. The orthogonal frequency division multiplex signal demodulator circuit according to Claim 6, wherein in order to decimate the outputs of the infinite impulse response digital filter by the degree 2 and to output the results, the operating frequency of the infinite impulse response digital filter is set to half the sampling frequency, and the signal processors of the n stages of signal processors connected in concatenation comprise only the signal processors of even-numbered stages from the output end.

**Patentansprüche**

1. OFDM-Demodulatorschaltung, umfassend:

einen Analog-/Digital-Wandler (1) zum Durchführen einer Analog-/Digital-Umwandlung eines eine von null verschiedene Mittenfrequenz aufweisenden empfangenen Signals mit einer Abtastfrequenz und zum Ausgeben eines digitalen Signals;
einen digitalen Quadratursignaldetektor (2), umfassend eine digitale Signalverzögerungsschaltung (8) zum Verzögern des digitalen Signals zwecks Erzeugung eines gleichphasigen Signals, und ein digitales Allpassfilter (7) zum Verschieben der Phase des digitalen Signals um 90°, um ein Quadratursignal zu erzeugen;
einen Frequenzschieber (3) zum Verschieben der Frequenzen des gleichphasigen Signals und des Quadratursignals, um diese in Basisbandsignale zu verwandeln, deren Mittenfrequenzen auf null liegen; und
einen OFDM-Detektor (6), gebildet aus einem schnellen Fourier-Transformator (13) zum Durchführen einer schnellen Fourier-Transformation der Basisbandsignale, und einen digitalen Demodulator (15) zum Demodulieren des digitalen Signals, welches der schnellen Fourier-Transformation unterzogen wurde,

**dadurch gekennzeichnet, dass** das digitale Allpassfilter ein digitales rekursives Filter ist, welches eine bestimmte Gruppenlaufzeit-Charakteristik besitzt, und
die digitale Signalverzögerungsschaltung eine Signalverzögerung aufweist, die der Gruppenlaufzeit des digitalen Allpassfilters gleicht.

2. Schaltung nach Anspruch 1, weiterhin umfassend einen Signaldezimator (4) zum Dezimieren des gleichphasigen Signals und des Quadratursignals um einen Grad 2, wobei der Dezimator an einen Ausgang des Frequenzschiebers angeschlossen ist.

3. Schaltung nach Anspruch 1, weiterhin umfassend einen Signaldezimator zum Dezimieren der Passbandsignale mit deren 0 betragenden Mittenfrequenzen um den Grad 2, wobei der Dezimator an den Eingang des Frequenzschiebers angeschlossen ist.

4. Schaltung nach Anspruch 2, bei der der Frequenzschieber aufweist:

einen Oszillator (9) zum Erzeugen eines Multiplikationssignals einer der halben Abtastfrequenz entsprechenden Frequenz;
einen Phasenschieber (10) zum Erzeugen eines Quadratur-Multiplikationssignals aus dem Multiplikationssignal; und
einen komplexen Multiplizierer (12) zum Erzeugen von Signalen, die aus der komplexen Summe von Produkten des Multiplikationssignals und des Quadratur-Multiplikationssignals für das gleichphasige Signal und das Quadratursignal bestehen, und zum
Ausgeben von Basisbandsignalen, von denen ein Zyklus aus vier Abtastpunkten besteht.

5. Schaltung nach Anspruch 3, bei der der Frequenzschieber aufweist:

einen Oszillator zum Erzeugen eines Multiplikationssignals einer der halben Abtastfrequenz entsprechenden Frequenz;

einen Phasenschieber zum Erzeugen eines Quadratur-Multiplikationssignals aus dem Multiplikationssignal; und

einen komplexen Multiplizierer zum Erzeugen von Multiplikationssignalen, bestehend aus der komplexen Summe von Produkten des Multiplikationssignals und des Quadratur-Multiplikationssignals für das phasengleiche Signal und das Quadratursignal, und zum

Ausgeben von Basisbandsignalen, von denen ein Zyklus aus zwei Abtastpunkten besteht.

6. Schaltung nach Anspruch 1, bei der das rekursive Digitalfilter aufweist:

eine beliebige ganzzahlige Anzahl n von drei oder mehr Stufen von Signalprozessoren ($7_1$ bis $7_8$), wobei zumindest die Prozessoren der geradzahligen Stufen verkettet sind und jeweils einen ersten Verzögerer ($7_{11}$ bis $7_{81}$), einen zweiten Verzögerer ($7_{12}$ bis $7_{82}$), einen Addierer ($7_{13}$ bis $7_{83}$), einen Multiplizierer ($7_{14}$ bis $7_{84}$) und einen Multiplikationskoeffizienten-Generator ($7_{15}$ bis $7_{85}$) aufweisen, und

die Koeffizienten sämtliche Multiplikationskoeffizienten-Generatoren der Signalprozessoren derart eingestellt sind, dass die in einem Signalband, dessen Mitte auf ein Viertel der Abtastfrequenz eingestellt ist, erzeugte Phasen-Gradientenzahl n-1 beträgt.

7. Schaltung nach Anspruch 6, bei der in den n-Stufen von Signalprozessoren der Signalprozessor einer ungeradzahligen Stufe bezüglich des Ausgangsendes nur einen ersten Verzögerer und einen zweiten Verzögerer aufweist.

8. Schaltung nach Anspruch 6, bei der zum Dezimieren der Ausgangssignale des rekursiven digitalen Filters um den Grad 2 und zum Ausgeben der Ergebnisse die Betriebsfrequenz des rekursiven Digitalfilters auf die halbe Abtastfrequenz eingestellt ist, und

die Signalprozessoren der n Stufen von Signalprozessoren, die verkettet sind, nur die Signalprozessoren der geradzahligen Stufen bezüglich des Ausgangsendes enthalten.

**Revendications**

1. Circuit démodulateur de signaux à multiplexage par répartition en fréquences orthogonales, comprenant :

un convertisseur analogique/numérique (1) permettant de réaliser une conversion analogique/numérique à une fréquence d'échantillonnage sur un signal reçu dont la fréquence centrale est non nulle, et de sortir un signal numérique ;

un détecteur de signaux en quadrature numérique (2), comprenant un circuit retardeur de signal numérique (8) permettant de retarder le signal numérique pour générer un signal en phase, et un filtre passe-tout numérique (7) permettant de déphaser le signal numérique de 90 degrés pour générer un signal en quadrature ;

un décaleur de fréquence (3) permettant de décaler les fréquences du signal en phase et du signal en quadrature pour les transformer en signaux en bande de base dont les fréquences centrales sont fixées à zéro ; et

un détecteur à multiplexage par répartition en fréquences orthogonales (6) composé d'un transformateur de Fourier rapide (13) permettant de réaliser une transformée de Fourier rapide sur les signaux en bande de base, et d'un démodulateur numérique (15) permettant de démoduler le signal numérique qui a été soumis à la transformée de Fourier rapide,

**caractérisé en ce que** le filtre passe-tout numérique est un filtre numérique à réponse impulsionnelle infinie ayant une caractéristique de retard de groupe prédéterminée, et

le circuit retardeur de signal numérique possède une quantité de retard de signal égale à la quantité de retard de groupe du filtre passe-tout numérique.

2. Circuit démodulateur de signaux à multiplexage par répartition en fréquences orthogonales selon la revendication 1, comprenant en outre un décimateur de signaux (4) permettant de décimer le signal en phase et le signal en quadrature du degré 2, le décimateur étant connecté à une extrémité de sortie du décaleur de fréquence.

3. Circuit démodulateur de signaux à multiplexage par répartition en fréquences orthogonales selon la revendication 1, comprenant en outre un décimateur de signaux permettant de décimer les signaux en bande de base dont les fréquences centrales sont nulles du degré 2, le décimateur étant connecté à une extrémité d'entrée du décaleur de fréquence.

4. Circuit démodulateur de signaux à multiplexage par répartition en fréquences orthogonales selon la revendication 2, dans lequel le décaleur de fréquence comprend :

un oscillateur (9) permettant de générer un signal de multiplication présentant une fréquence qui est égale à la moitié d'une fréquence d'échantillonnage ;
un déphaseur (10) permettant de produire un signal de multiplication en quadrature à partir du signal de multiplication ; et
un multiplicateur complexe (11) permettant de produire des signaux composés de la somme complexe de produits du signal de multiplication et du signal de multiplication en quadrature pour les signaux en phase et les signaux en quadrature, et permettant de
sortir des signaux en bande de base, dont un cycle est composé de 4 points d'échantillonnage.

5. Circuit démodulateur de signaux à multiplexage par répartition en fréquences orthogonales selon la revendication 3, dans lequel le décaleur de fréquence comprend :

un oscillateur permettant de générer un signal de multiplication présentant une fréquence égale à la moitié d'une fréquence d'échantillonnage ;
un déphaseur permettant de produire un signal de multiplication en quadrature à partir du signal de multiplication ; et
un multiplicateur complexe permettant de produire des signaux composés de la somme complexe de produits du signal de multiplication et du signal de multiplication en quadrature pour le signal en phase et le signal en quadrature, et permettant de :

sortir des signaux en bande de base, dont un cycle est composé de 2 points d'échantillonnage.

6. Circuit démodulateur de signaux à multiplexage par répartition en fréquences orthogonales selon la revendication 1, dans lequel :

le filtre numérique à réponse impulsionnelle infinie comprend un entier arbitraire n présentant trois étages de processeurs de signaux ($7_1$ à $7_8$) ou plus, au moins les processeurs des étages pairs étant connectés d'une manière concaténée et chacun ayant un premier retardeur ($7_{11}$ à $7_{81}$), un deuxième retardeur ($7_{12}$ à $7_{82}$), un additionneur ($7_{13}$ à $7_{83}$), un multiplicateur ($7_{14}$ à $7_{84}$), et un générateur de coefficients de multiplication ($7_{15}$ à $7_{85}$), et
les coefficients de tous les générateurs de coefficients de multiplication des processeurs de signaux sont définis de telle sorte que le nombre de gradients de phase générés dans une bande de signaux dont le centre est fixé à un quart de la fréquence d'échantillonnage est égal à n-1.

7. Circuit démodulateur de signaux à multiplexage par répartition en fréquences orthogonales selon la revendication 6, dans lequel :

dans les n étages de processeurs de signaux, le processeur de signaux d'un étage impair à partir de l'extrémité de sortie ne comprend qu'un premier retardeur et un deuxième retardeur.

8. Circuit démodulateur de signaux à multiplexage par répartition en fréquences orthogonales selon la revendication 6, dans lequel :

afin de décimer les sorties du filtre numérique à réponse impulsionnelle infinie du degré 2 et de sortir les résultats, la fréquence opérationnelle du filtre numérique à réponse impulsionnelle infinie est fixée à la moitié de la fréquence d'échantillonnage, et
les processeurs de signaux des n étages des processeurs de signaux connectés d'une manière concaténée ne comprennent que les processeurs de signaux des étages impairs à partir de l'extrémité de sortie.

# FIG. 1

OFDM DETECTOR 6

15 — DEM

14 — P/S

13 — FFT

12 — S/P

POINT N IFFT

5 — GL ELIMI-NATOR

4 — DECI-MATOR

FREQUENCY SHIFTER 3

11 — X/P

9

270° — 10

FREQUENCY: fs/2

DIGITAL QUADRATURE SIGNAL DETECTOR 2

8 — DL

7 — IIR

1 — A/D

Sin

A  B  C  D

I  Q

SAMPLING FREQUENCY (DATA RATE)

fd

fs/N

fs

2fs

FIG. 2A

WAVEFORM A

OFDM
MODULATED
SIGNAL

(IF OF SINGLE
SYSTEM)

fs/2    fs           2fs

FIG. 2B

WAVEFORM B

(IF OF TWO
SYSTEMS I AND Q)

fs/2    fs           2fs

FIG. 2C

WAVEFORM C

fs/2    fs           2fs

FIG. 2D

WAVEFORM D

fs/2    fs

# FIG. 3

EP 1 274 211 B1

# FIG. 4

# FIG. 5

DELAY
TIME

GROUP DELAY TIME OF
ALL-PASS FILTERS

DELAY TIME OF DIGITAL
DELAY CIRCUIT

N × ts

ts: SAMPLING TIME
(= 1/fs)

fs/4          fs/2          fs    FREQUENCY

SIGNAL BAND

20

# FIG. 6

# FIG. 7

# FIG. 8

# FIG. 9

| PHASE GRA-DIENT | NUMBER OF COEFFI-CIENTS | C1 | C2 | C3 | C4 | C5 | C6 | C7 | C8 | C9 | C10 |
|---|---|---|---|---|---|---|---|---|---|---|---|
| 4 | 5 | $2.5*10^{-7}$ | $-4.7*10^{-1}$ | $-9.1*10^{-7}$ | $-9.3*10^{-2}$ | $-3.2*10^{-6}$ | — | — | — | — | — |
| | 4 | $-9.6*10^{-1}$ | $4.2*10^{-1}$ | $-3.3*10^{-1}$ | $1.2*10^{-1}$ | — | — | — | — | — | — |
| | 6 | $1.0*10^{+0}$ | $-5.2*10^{-1}$ | $-4.6*10^{-1}$ | $-1.1*10^{-1}$ | $-8.2*10^{-2}$ | $-3.0*10^{-2}$ | — | — | — | — |
| 6 | 7 | $-2.8*10^{-6}$ | $-4.8*10^{-1}$ | $3.0*10^{-6}$ | $-9.6*10^{-2}$ | $3.5*10^{-6}$ | $-3.2*10^{-2}$ | $2.2*10^{-6}$ | — | — | — |
| | 6 | $-9.7*10^{-1}$ | $4.6*10^{-1}$ | $-4.0*10^{-1}$ | $2.5*10^{-1}$ | $-1.8*10^{-1}$ | $7.8*10^{-3}$ | — | — | — | — |
| | 8 | $1.0*10^{+0}$ | $-5.1*10^{-1}$ | $-4.7*10^{-1}$ | $-1.1*10^{-1}$ | $-8.9*10^{-2}$ | $-4.1*10^{-2}$ | $-2.8*10^{-2}$ | $-1.2*10^{-2}$ | — | — |
| 8 | 9 | $-3.8*10^{-8}$ | $-4.8*10^{-1}$ | $-1.6*10^{-1}$ | $-1.0*10^{-1}$ | $1.1*10^{-7}$ | $-3.6*10^{-2}$ | $9.3*10^{-9}$ | $-1.3*10^{-2}$ | $-2.1*10^{-8}$ | — |
| | 8 | $-9.8*10^{-1}$ | $4.7*10^{-1}$ | $-4.2*10^{-1}$ | $2.8*10^{-1}$ | $-2.3*10^{-1}$ | $1.5*10^{-1}$ | $-1.0*10^{-1}$ | $4.9*10^{-2}$ | — | — |
| | 10 | $1.0*10^{+0}$ | $-5.1*10^{-1}$ | $-4.7*10^{-1}$ | $-1.1*10^{-1}$ | $-9.6*10^{-2}$ | $-4.4*10^{-2}$ | $-3.3*10^{-2}$ | $-1.8*10^{-2}$ | $-1.2*10^{-2}$ | $-5.4*10^{-3}$ |

EP 1 274 211 B1

## FIG. 10

| PHASE GRA-DIENT | NUMBER OF COEFFI-CIENTS | C1 | C2 | C3 | C4 | C5 | C6 | C7 | C8 | C9 |
|---|---|---|---|---|---|---|---|---|---|---|
| 2 | 3 | $-4.8*10^{-5}$ | $-4.9*10^{-1}$ | $3.7*10^{-6}$ | — | — | — | — | — | — |
| 3 | 4 | $-6.0*10^{-8}$ | $-4.7*10^{-1}$ | $8.2*10^{-8}$ | $-9.3*10^{-2}$ | — | — | — | — | — |
| 4 | 5 | $2.5*10^{-7}$ | $-4.7*10^{-1}$ | $-9.1*10^{-7}$ | $-9.3*10^{-2}$ | $-3.2*10^{-6}$ | — | — | — | — |
| 5 | 6 | $-1.2*10^{-6}$ | $-4.8*10^{-1}$ | $1.8*10^{-7}$ | $-9.6*10^{-2}$ | $-8.7*10^{-7}$ | $-3.2*10^{-2}$ | — | — | — |
| 6 | 7 | $-2.8*10^{-6}$ | $-4.8*10^{-1}$ | $3.0*10^{-6}$ | $-9.6*10^{-2}$ | $3.5*10^{-6}$ | $-3.2*10^{-2}$ | $2.2*10^{-6}$ | — | — |
| 7 | 8 | $3.7*10^{-8}$ | $-4.8*10^{-1}$ | $-1.7*10^{-7}$ | $-1.0*10^{-1}$ | $2.1*10^{-7}$ | $-3.6*10^{-2}$ | $1.2*10^{-8}$ | $-1.3*10^{-2}$ | — |
| 8 | 9 | $-3.8*10^{-8}$ | $-4.8*10^{-1}$ | $-1.6*10^{-7}$ | $-1.0*10^{-1}$ | $1.1*10^{-7}$ | $-3.6*10^{-2}$ | $9.3*10^{-9}$ | $-1.3*10^{-2}$ | $-2.1*10^{-8}$ |

EP 1 274 211 B1

# FIG. 11

EP 1 274 211 B1

## FIG. 12

# FIG. 13A

FREQUENCY SHIFTER

$S_I$

X/P

$S_Q$

$S'_I = S_I \times L_I - S_Q \times L_Q$

$S'_Q = S_I \times L_Q + S_Q \times L_I$

$L_Q$   $L_I$

270°

FREQUENCY: fs/2

# FIG. 13B

$L_I$

1

0        0        TIME

-1

SAMPLING POINT

$L_Q$

0        0        TIME

-1

1

SAMPLING POINT

TIME

| $S'_I$ | $S_I$ | $S_Q$ | $-S_I$ | $-S_Q$ | ... |
|------|------|------|------|------|-----|
| $S'_Q$ | $S_Q$ | $-S_I$ | $-S_Q$ | $S_I$ | ... |

# FIG. 13C

I

$17_I$

180°

I
Q
-I
-Q

$16_I$

I

Q

$17_Q$

180°

Q
-I
-Q
I

$16_Q$

Q

# FIG. 14

DIGITAL
QUADRATURE
SIGNAL
DETECTOR 2

FREQUENCY
SHIFTER 3

OFDM DETECTOR 6

Sin — A/D — 1 — A — DL 8 — B — I — DECI-MATOR 4 — C — X/P 11 — E — GL ELIMI-NATOR 5 — S/P 12 — FFT 13 — P/S 14 — I / Q — DEM 15

IIR 7 — Q

270° 10

FREQUENCY fs/2 9

POINT N IFFT

2fs — fs — fs/N — fd

SAMPLING FREQUENCY (DATA RATE)

EP 1 274 211 B1

FIG. 15A

WAVEFORM A

OFDM
MODULATED
SIGNAL

(IF OF SINGLE
SYSTEM)

fs/2    fs        2fs

FIG. 15B

WAVEFORM B

(IF OF TWO
SYSTEMS I AND Q)

fs/2    fs        2fs

FIG. 15C

WAVEFORM C

fs/2    fs

FIG. 15D

WAVEFORM D

fs/2    fs

# FIG. 16A

FREQUENCY
SHIFTER

$S_I \rightarrow$ X/P $\rightarrow$ $S'_I = S_I \times L_I - S_Q \times L_Q$

$S_Q \rightarrow$ $\rightarrow$ $S'_Q = S_I \times L_Q + S_Q \times L_I$

$L_Q \uparrow \quad \uparrow L_I$

270°

FREQUENCY:
fs/2

# FIG. 16B

$L_I$

1 ............ 1 —— SAMPLING POINT

—————→ TIME

-1

$L_Q$

0 ............ SAMPLING POINT

————→ TIME

0          0

—————→ TIME

| $S'_I$ | $S_I$ | $-S_I$ | . . . |
|--------|-------|--------|-------|
| $S'_Q$ | $S_Q$ | $-S_Q$ | . . . |

# FIG. 16C

I $\rightarrow$ ———— I $\rightarrow$ ---18$_I$

19$_I$

180° $\rightarrow$ -I

I

Q $\rightarrow$ ———— Q $\rightarrow$ ---18$_Q$

19$_Q$

180° $\rightarrow$ -Q

Q

# FIG. 17

## FIG. 18
### PRIOR ART

DIGITAL QUADRATURE
SIGNAL DETECTOR 82

OFDM DETECTOR 85

80

SAMPLING FREQUENCY (DATA RATE)

EP 1 274 211 B1

FIG. 19A
PRIOR ART

WAVEFORM A

fs/2   fs        2fs

FIG. 19B
PRIOR ART

WAVEFORM B

F

AMPLITUDE
CHARACTERISTICS
OF LPF

fs/2   fs        2fs

FIG. 19C
PRIOR ART

WAVEFORM C

fs/2   fs        2fs

FIG. 19 D
PRIOR ART

WAVEFORM D

OFDM MODULATED
SIGNAL

fs/2   fs